(19) Europäisches Patentamt
European Patent Office
Office européen des brevets

(11) **EP 3 440 514 B1**

(12) **EUROPÄISCHE PATENTSCHRIFT**

(45) Veröffentlichungstag und Bekanntmachung des Hinweises auf die Patenterteilung:
**04.03.2020  Patentblatt 2020/10**

(21) Anmeldenummer: **17717613.8**

(22) Anmeldetag: **05.04.2017**

(51) Int Cl.:
**G04G 3/04** (2006.01)

(86) Internationale Anmeldenummer:
**PCT/AT2017/060084**

(87) Internationale Veröffentlichungsnummer:
**WO 2017/173472 (12.10.2017 Gazette 2017/41)**

(54) **VERFAHREN UND VORRICHTUNG ZUR ERZEUGUNG EINER REFERENZFREQUENZ**

METHOD AND DEVICE FOR GENERATING A REFERENCE FREQUENCY

METHODE ET APPAREIL POUR GENERER UNE FREQUENCE DE REFERENCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.04.2016  AT 502822016**

(43) Veröffentlichungstag der Anmeldung:
**13.02.2019  Patentblatt 2019/07**

(73) Patentinhaber: **Technische Universität Wien**
**1040 Wien (AT)**

(72) Erfinder: **TRUPKE, Michael**
**1010 Wien (AT)**

(74) Vertreter: **KLIMENT & HENHAPEL**
**Patentanwälte OG**
**Gonzagagasse 15/2**
**1010 Wien (AT)**

(56) Entgegenhaltungen:
**US-A- 3 826 931    US-A1- 2012 320 449**

EP 3 440 514 B1

**Beschreibung**

GEBIET DER ERFINDUNG

Die vorliegende Erfindung betrifft ein Verfahren zur Erzeugung einer Referenzfrequenz gemäß dem Oberbegriff des Anspruchs 1. Die vorliegende Erfindung betrifft außerdem eine Vorrichtung zur Erzeugung einer Referenzfrequenz gemäß dem Oberbegriff des Anspruchs 13. Bevorzugte Ausführungsformen sind in den abhängigen Ansprüchen 2 bis 12, 14 und 15 definiert.

STAND DER TECHNIK

Frequenzreferenzen bzw. deren Erzeugung sind in unterschiedlichen Formen bekannt. Als Beispiele seien Quarzoszillatoren, Mikrowellenübergänge in atomaren Grundzuständen (Rubidiumofen, Cäsiumreferenz, Wasserstoffmaser) und optische Übergänge in Atomen (Strontium) oder Ionen (Aluminium) genannt. Im alltäglichen Gebrauch werden aus Kostengründen hauptsächlich Quarzoszillatoren verwendet, während Atomreferenzen dort im Einsatz sind, wo höhere Genauigkeiten erforderlich sind, zum Beispiel im wissenschaftlichen, militärischen oder telekommunikationstechnischen Bereich. Wichtige Anwendungen, neben der Zeitmessung selbst, sind Navigation mittels Satellitensignalen (z.B. GPS) oder direkte Navigation mittels Beschleunigungsmessung sowie Netzwerksynchronisation und Frequenzzuweisung für Kommunikationskanäle in Radio-, Satelliten- oder Zellulärnetzwerken.

Quarzoszillatoren sind günstig und kompakt und können mittels thermischer Stabilisierung, Zeitverzögerungen von unter 100 Millisekunden pro Jahr und Kurzzeitstabilitäten von unter 1 Pikosekunde pro Sekunde aufweisen. Günstige Quarzreferenzen, wie sie in kommerziellen Navigationssystemen verwendet werden, haben Genauigkeiten im Bereich von $10^{-6}$, während militärische Systeme mit feiner Temperaturkompensation Genauigkeiten im Bereich von $10^{-8}$ bis $10^{-10}$ besitzen. Diese Genauigkeit erlaubt eine präzisere Lokalisierung, da die Position relativ zu den Positionierungssatelliten mittels der Lichtgeschwindigkeit in Zeiteinheiten ausgedrückt wird. Atomare Referenzen sind deutlich kostspieliger, bieten dafür aber wesentlich höhere Genauigkeit. Cäsiumuhren sind der internationale Standard auf deren Basis die Sekunde definiert ist, und sind somit per Definition absolut genau. Sie weisen jedoch trotzdem Kurzzeitschwankungen auf, zum Beispiel wegen der endlichen Wechselwirkungszeit der Atome mit dem oszillierenden Feld. Strontiumuhren und Aluminiumionenuhren sind die genauesten bekannten Referenzen, benötigen jedoch hochkomplexe Lasersysteme und Fallen um die Atome zu kühlen, zu halten und deren Resonanzfrequenz zu messen. Zudem können die hierdurch zur Verfügung gestellten Referenzfrequenzen nicht oder nur unzureichend gewählt bzw. variiert werden. Weitere Informationen zu Quarzreferenzen und atombasierten Frequenzreferenzen sind in Ref. 1 ["Quartz Crystal Resonators and Oscillators for Frequency Control and Timing Applications - A Tutorial"; J. R. Vig; Rev. 8.5.6.2; erhältlich auf http://www.ieee-uffc.org/frequency-control] gegeben.

Optische Resonatoren werden seit geraumer Zeit auch als Frequenzreferenzen angewendet, hauptsächlich um die optische Frequenz eines Lasers zu stabilisieren, wie in Ref. 2 ["Laser-Based Measurements for Time and Frequency Domain Applications: A Handbook"; P. Maddaloni, M. Bellini, P. De Natale; Taylor & Francis (2013)] beschrieben. Ein Vorteil solcher Referenzen ist die ununterbrochene Wechselwirkung des Lichts mit dem Resonator. Nachteile sind die Vibrationsabhängigkeit, Frequenzverschiebungen durch Längenveränderung und Frequenzverschiebung durch Ablagerungen auf oder Materialveränderungen in den Spiegeloberflächen. Im Gegensatz zu quarzbasierten Referenzen benötigen optische Referenzen keine beweglichen Teile. Anders als atombasierte Referenzen besitzen optische Referenzen auch keine intrinsische Magnetfeldabhängigkeit. Optische Referenzen sind deutlich kostengünstiger als atomare Referenzen, erreichen jedoch nicht deren Genauigkeit.

Andererseits wäre es auch im Hinblick auf die zunehmende Umstellung von elektronischen Methoden auf optische Verfahren in Telekommunikation und Datenverarbeitung wünschenswert, hochgenaue optische Referenzen zu haben, welche nahtlos in moderne Datenverbreitungs- und Datenverarbeitungsstrukturen integriert werden können.

Schließlich besteht neben den genannten Anwendungsproblemen das fundamentale theoretische Problem, dass die derzeitigen atomaren Zeitstandards von physikalischen Größen wie der Feinstrukturkonstante abhängen. Insofern hätte eine langzeitstabile, rein optische Referenz, die nur von Geometrie und Lichtgeschwindigkeit bestimmt wird, einen grundlegenden Reiz, wobei jedoch derzeit die erforderliche Genauigkeit, um mit atomaren Referenzen konkurrieren zu können, von optischen Referenzen nicht erreichbar ist.

Aus der US 2012/320449 A1 ist ein Verfahren gemäß dem Oberbegriff des Anspruchs 1 bekannt.

Aus der US 3826931 A ist es bekannt, bei piezoelektrischen Quarzoszillatoren unterschiedliche Vibrationsmoden dieser Quarzoszillatoren algebraisch zu kombinieren, um eine Temperaturabhängigkeit des Kombinationsergebnisses möglichst zu eliminieren.

## AUFGABE DER ERFINDUNG

Es ist daher Aufgabe der vorliegenden Erfindung, ein Verfahren sowie eine Vorrichtung zur Erzeugung einer Referenzfrequenz zur Verfügung zu stellen, welche die oben genannten Nachteile vermeidet. Insbesondere soll die Referenzfrequenz gleichzeitig hochstabil und vergleichsweise kostengünstig sein. Vorzugsweise soll die Referenzfrequenz in einem Frequenzbereich zwischen ca. 100 MHz und mehreren Terahertz liegen und dabei möglichst frei wählbar sein. Besonders bevorzugt, soll das erfindungsgemäße Verfahren bzw. die erfindungsgemäße Vorrichtung die Integration der Erzeugung der Referenzfrequenz in photonische Strukturen, wie sie zunehmend in der Kommunikations- und Datenverarbeitungstechnik eingesetzt werden, erlauben.

## DARSTELLUNG DER ERFINDUNG

Kern der Erfindung ist die Erkenntnis, dass optische Resonatoren so ausgelegt werden können, dass im Bereich der erwünschten Betriebsparameter (wie z.B. eines Drucks oder einer Temperatur; grundsätzlich wären beispielsweise aber auch magnetische oder elektrische Feldstärken denkbar) zwei unterschiedliche optische Moden zwar jeweils eine Abhängigkeit ihrer Frequenz von Änderungen der Betriebsparameter, insbesondere der Länge oder der Temperatur des jeweiligen Resonators zeigen, diese Abhängigkeit für die beiden Moden jedoch nahezu die gleiche Empfindlichkeit aufweist. Folglich ist die Differenz $\Delta f$ zwischen der Frequenz f1 der ersten Mode und der Frequenz f2 der zweiten Mode, d.h. $\Delta f = |f1 - f2|$, gegenüber den Parameteränderungen stabil, sodass $\Delta f$ als stabile Referenzfrequenz dienen kann. Dabei haben Rechnungen gezeigt, dass für ein annähernd gleiches Verhalten der Moden in Abhängigkeit eines Betriebsparameters, insbesondere der Resonatorlänge oder der Temperatur, eine geringfügige Abweichung der Empfindlichkeiten von f1 und f2 tolerierbar ist, die typischerweise bis zu $\pm 0,1\%$ betragen kann. Anzumerken ist hierbei, dass unter optischen Moden im Allgemeinen nicht unbedingt sichtbares Licht zu verstehen ist, sondern es sich auch um langwelligere oder kurzwelligere Moden handeln kann.

Entsprechend ist erfindungsgemäß ein Verfahren zur Erzeugung einer Referenzfrequenz $\Delta f$ unter Verwendung eines ersten optischen Resonators und eines zweiten optischen Resonators vorgesehen, wobei der erste Resonator eine erste Resonatormode mit einer ersten Frequenz f1 aufweist und der zweite Resonator eine zweite Resonatormode mit einer zweiten Frequenz f2, wobei die Frequenzen der beiden Resonatormoden Funktionen eines Betriebsparameters BP, insbesondere einer Temperatur, sind und die Werte f1 und f2 bei einem vorgegeben Wert $BP_0$ des Betriebsparameters annehmen, sodass $f1(BP_0)=f1$ und $f2(BP_0)=f2$ gilt, wobei die Resonatoren so ausgelegt werden, dass die erste Ableitung der Frequenzen f1(BP), f2(BP) nach BP oder zumindest ein Differenzenquotient rund um $BP_0$ bis auf eine Abweichung von maximal $\pm 0,1\%$ übereinstimmen, wobei Licht der ersten Frequenz f1 mittels des ersten Resonators auf die erste Frequenz f1 stabilisiert wird und Licht der zweiten Frequenz f2 mittels des zweiten Resonators auf die zweite Frequenz f2, und wobei die Differenz zwischen den stabilisierten Frequenzen f1 und f2, $\Delta f = |f1 - f2|$, bestimmt wird, um die stabilisierte Referenzfrequenz $\Delta f$ zu erhalten.

Die prozentuale Abweichung kann dabei auf f1 oder f2 bezogen sein.

Erläuternd sei bemerkt, dass die genannte Abweichung grundsätzlich vom Schwankungsbereich des Betriebsparameters BP abhängt. Wenn zum Beispiel für die Temperatur als Betriebsparameter eine Stabilisierung auf $\pm 1$ mK erreicht werden kann, dann wird ein Unterschied zwischen den thermischen Koeffizienten von 0.1% zu einer Stabilität von $10^{-6}$ führen, was einem günstigen Quarzoszillator entspricht.

Zur Erzeugung des Lichts der Resonatormoden werden üblicherweise Laser verwendet, es können jedoch auch andere Lichtquellen verwendet werden. Letzteres gilt insbesondere deswegen, weil das Prinzip der Erfindung grundsätzlich nicht auf den optischen Wellenlängenbereich begrenzt ist, d.h. man kann prinzipiell analog auch bei kürzeren oder längeren Wellenlängen vorgehen, z.B. bei mit Radio-, Mikrowellen- oder Terahertzsystemen.

Dabei kann auch ein einzelner Laser verwendet werden, der grundsätzlich Licht der Frequenz f1 erzeugt und der gleichzeitig in an sich bekannter Weise, z.B. mittels eines akustooptischen Frequenzschiebers, dazu verwendet werden kann, auch Licht der Frequenz f2 zu erzeugen. Analog ist daher erfindungsgemäß eine Vorrichtung zur Erzeugung einer Referenzfrequenz $\Delta f$ vorgesehen, wobei ein erster optischer Resonator vorgesehen ist, der eine erste Resonatormode mit einer ersten Frequenz f1 aufweist, und ein zweiter optischer Resonator, der eine zweite Resonatormode mit einer zweiten Frequenz f2 aufweist, wobei die Frequenzen der beiden Resonatormoden Funktionen eines Betriebsparameters BP, insbesondere einer Temperatur, sind und die Werte f1 und f2 bei einem vorgegeben Wert $BP_0$ des Betriebsparameters annehmen, sodass $f1(BP_0)=f1$ und $f2(BP_0)=f2$ gilt, wobei die Resonatoren so ausgelegt sind, dass die erste Ableitung der Frequenzen f1(BP), f2(BP) nach BP oder zumindest ein Differenzenquotient rund um $BP_0$ bis auf eine Abweichung von maximal $\pm 0,1\%$ übereinstimmen, die Vorrichtung weiters umfassend erste Lichterzeugungsmittel zur Erzeugung von Licht der ersten Frequenz f1 und zweite Lichterzeugungsmittel zur Erzeugung von Licht der zweiten Frequenz f2, wobei die ersten Lichterzeugungsmittel und die zweiten Lichterzeugungsmittel vorzugsweise insgesamt mindestens einen Laser umfassen, die Vorrichtung weiters umfassend erste Stabilisierungsmittel, um die erste Frequenz f1 zu stabilisieren, und zweite Stabilisierungsmittel, um die zweite Frequenz f2 zu stabilisieren, und wobei Bestimmungsmittel vorgesehen sind, um die Differenz zwischen den stabilisierten Frequenzen f1 und f2, $\Delta f = |f1 - f2|$, zu bestimmen und die stabilisierte Referenzfrequenz $\Delta f$ zu erhalten.

Die wesentliche Einflussgröße bzw. der wesentliche Betriebsparameter ist in der Praxis die Temperatur, da diese eine Änderung der Dimensionen, insbesondere der Resonatorlänge des jeweiligen Resonators bewirkt. Die Frequenz f1 der ersten Mode eines ersten Resonators einer Resonatorlänge $L_1$ ist im Falle eines Fabry-Perot-Resonators gegeben durch die Bedingung $f1 = c*m_1/(2*n_1*L_1)$, wobei c die Lichtgeschwindigkeit ist, $n_1$ der Brechungsindex für die erste Resonatormode im ersten Resonator und $m_1$ eine ganze Zahl. Dies gilt für eine gewisse Temperatur, einer Arbeitspunkttemperatur, bei der die Resonatorlänge $L_1$ vorliegt. Berücksichtigt man die Temperaturabhängigkeit der Resonatorlänge $L_1$ mittels eines linearen Temperaturkoeffizienten $\beta_1$ des ersten Resonators so ergibt sich die temperaturabhängige Frequenz f1 zu $f1(T) = c*m_1/(2*L_1*(1+\beta_1*T))$, wobei T die Temperaturdifferenz zur Arbeitspunkttemperatur angibt. Näherungsweise ergibt sich somit $f1(T) = c*m_1*(1-\beta_1*T)/(2*L_1)$.

Analog erhält man für die temperaturabhängige Frequenz f2 eines zweiten Resonators der Resonatorlänge $L_2$ näherungsweise $f2(T) = c*m_2*(1-\beta_2*T)/(2*L_2)$, wobei $m_2$ eine ganze Zahl ist, $n_2$ der Brechungsindex der zweiten Resonatormode im zweiten Resonator und $\beta_2$ der lineare Temperaturkoeffizient des zweiten Resonators. Bildet man nun die Differenz f1(T)-f2(T)und setzt deren Ableitung nach T null, so erhält man folgende Bedingung, die erfüllt sein muss, um ein exakt gleiches Temperaturverhalten der beiden Moden zu erzielen:

$$m_1*\beta_1*L_2*n_2 \ = \ m_2*\beta_2*L_1*n_1$$

Genau dieselbe Bedingung ergibt sich auch, wenn man von Ringresonatoren, auch als Flüstergaleriemoden-Resonatoren bezeichnet, ausgeht, wobei in diesem Fall die Resonatorlängen $L_1$, $L_2$ durch die Umfänge der Resonatoren gegeben sind und näherungsweise

$$f1,2(T) \ = \ c*m_{1,2}*(1-\beta_{1,2}*T)/(2*L_{1,2})$$

gilt. Die ganzen Zahlen $m_1$, $m_2$ können daher als Anzahl der Wellenlängen der ersten bzw. zweiten Resonatormode im ersten bzw. zweiten Resonator aufgefasst werden.

Unter Heranziehung obiger Bedingung kann somit die Auslegung der Resonatoren durch den Fachmann so erfolgen, dass bekannte Geometrien und die linearen Temperaturkoeffizienten - insbesondere durch geeignete Materialwahl - entsprechend angepasst werden. Insbesondere kann bei bekanntem Material eine entsprechende Dimensionierung durchgeführt werden bzw. kann bei vorgegebener Dimensionierung eine entsprechende Materialwahl getroffen werden.

Typischerweise erfolgt dabei zunächst eine numerische Behandlung und basierend auf dieser die Fertigung des Resonators. Dabei kann es aufgrund von Fertigungstoleranzen zu einer geringfügigen Abweichung von obiger Gleichung bei einer gewissen Arbeitspunkttemperatur $T_1$ kommen. D.h. die Gleichung wäre in diesem Fall nur dann erfüllt, wenn $m_{1,2}$ keine ganzen Zahlen sind. In der Praxis zeigt es sich jedoch, dass einerseits über eine gezielte Temperaturänderung bzw. Anpassung der Temperatur die Eigenschaften der optischen Resonatoren derart geändert werden können, dass die Gleichung bei einer weiteren Arbeitspunkttemperatur $T_2 \neq T_1$ schließlich erfüllt ist.

Andererseits haben aufwendige Rechnungen und Versuche gezeigt, dass für ein annähernd gleiches Verhalten der Moden in Abhängigkeit eines Parameters, insbesondere der Resonatorlänge oder der Temperatur, die obige Gleichung nicht identisch erfüllt zu sein braucht, sondern eine geringfügige Abweichung tolerierbar ist, die typischerweise bis zu 0,1% betragen kann. Erst bei größeren Abweichungen wird die erzielbare Stabilität der Referenzfrequenz so gering, dass andere Methoden wie z.B. die Erzeugung einer Referenzfrequenz mittels Quarzoszillatoren in der Praxis interessanter sind, insbesondere aus Kostengründen. D.h. die zu erfüllende Auslegungsbedingung für die Auslegung der Resonatoren lautet

$$m_1*\beta_1*L_2*n_2 \ = \ m_2*\beta_2*L_1*n_1 \ \pm \ 0,1\%$$

oder in Worten:

$$m_1*\beta_1*L_2*n_2 \ = \ m_2*\beta_2*L_1*n_1$$

bis auf eine Abweichung von maximal $\pm 0,1\%$.

Die prozentuale Abweichung kann dabei auf die linke Seite ($m_1*\beta_1*L_2*n_2$) oder auf die rechte Seite ($m_2*\beta_2*L_1*n_1$) der Gleichung bezogen sein.

Alternativ kann ein stabiles Modenpaar, also eine erste Resonatormode und eine zweite Resonatormode, deren Frequenzen ein annähernd gleiches Temperaturverhalten aufweisen, durch Kopplung zweier Moden erzeugt werden. Die Kopplung, die durch entsprechende Auslegung der Resonatoren in an sich bekannter Weise erfolgen kann, bewirkt ein aufgespaltenes Modenspektrum, wobei die Stärke der Kopplung, $2*g$, die Referenzfrequenz $\Delta f$ darstellt. Entsprechend können im aufgespaltenen Modenspektrum zwei aufeinander folgende Moden gefunden werden, die die erste Resonatormode mit Frequenz f1 und die zweite Resonatormode f2 ausbilden, wobei $\Delta f = |f1 - f2|$ gilt. Die beiden gekoppelten Resonatormoden werden im Folgenden auch als gekoppeltes Modenpaar bezeichnet.

Daher ist es bei einer bevorzugten Ausführungsform des erfindungsgemäßen Verfahrens vorgesehen, dass der erste optische Resonator eine Resonatorlänge $L_1$ und einen linearen Temperaturkoeffizienten $\beta_1$ aufweist und der zweite optische Resonator eine Resonatorlänge $L_2$ und einen linearen Temperaturkoeffizienten $\beta_2$, wobei die Resonatoren so ausgelegt werden, dass $m_1*\beta_1*L_2*n_2 = m_2*\beta_2*L_1*n_1$ bis auf eine Abweichung von maximal $\pm 0,1\%$ gilt mit $m_1$, $m_2$ ganzen Zahlen, die der Anzahl der Wellenlängen der ersten bzw. zweiten Resonatormode im ersten bzw. zweiten Resonator entsprechen, und $n_1$, $n_2$ den Brechungsindizes für die erste Resonatormode im ersten Resonator und die zweite Resonatormode im zweiten Resonator oder dass im ersten und zweiten Resonator gekoppelte Moden vorliegen und ein aufgrund der Kopplung aufgespaltetes Modenspektrum die erste Resonatormode und die zweite Resonatormode enthält.

Analog zum oben Gesagten ist es bei einer bevorzugten Ausführungsform der erfindungsgemäßen Vorrichtung vorgesehen, dass der erste optische Resonator eine Resonatorlänge $L_1$ und einen linearen Temperaturkoeffizienten $\beta_1$ aufweist und der zweite optische Resonator eine Resonatorlänge $L_2$ und einen linearen Temperaturkoeffizienten $\beta_2$, wobei die Resonatoren so ausgelegt sind, dass $m_1*\beta_1*L_2*n_2 = m_2*\beta_2*L_1*n_1$ bis auf eine Abweichung von maximal $\pm 0,1\%$ gilt mit $m_1$, $m_2$ ganzen Zahlen, die der Anzahl der Wellenlängen der ersten bzw. zweiten Resonatormode im ersten bzw. zweiten Resonator entsprechen, und $n_1$, $n_2$ den Brechungsindizes für die erste Resonatormode im ersten Resonator und die zweite Resonatormode im zweiten Resonator oder dass im ersten und zweiten Resonator gekoppelte Moden vorliegen und ein aufgrund der Kopplung aufgespaltetes Modenspektrum die erste Resonatormode und die zweite Resonatormode enthält.

Zur Stabilisierung der Frequenzen f1, f2 können grundsätzlich unterschiedlichste aus dem Stand der Technik bekannte Mittel bzw. Verfahren verwendet werden. Ein wohletabliertes Verfahren ist das Pound-Drever-Hall-Verfahren. Entsprechend ist es bei einer bevorzugten Ausführungsform der erfindungsgemäßen Vorrichtung vorgesehen, dass die ersten Stabilisierungsmittel erste Modulationsmittel umfassen, um dem Licht erster Frequenz f1 Seitenbänder aufzumodulieren, und erste Demodulationsmittel mit einem ersten Detektor, um mittels des zum ersten Detektor zurück reflektierten oder transmittierten modulierten Lichts erster Frequenz f1 ein erstes Fehlersignal zu erzeugen, sowie erste Regelmittel, um anhand des ersten Fehlersignals die ersten Lichterzeugungsmittel so zu regeln, dass die erste Frequenz f1 stabilisiert wird, und dass die zweiten Stabilisierungsmittel zweite Modulationsmittel umfassen, um dem Licht zweiter Frequenz f2 Seitenbänder aufzumodulieren, und zweite Demodulationsmittel mit einem zweiten Detektor, um mittels des zum zweiten Detektor zurück reflektierten oder transmittierten modulierten Lichts zweiter Frequenz f2 ein zweites Fehlersignal zu erzeugen, sowie zweite Regelmittel, um anhand des zweiten Fehlersignals die zweiten Lichterzeugungsmittel so zu regeln, dass die zweite Frequenz f2 stabilisiert wird. D.h. es wird mit den Demodulationsmitteln die Symmetrie der Intensität der Seitenbänder rund um die zentrale Frequenz bestimmt und das Licht solange feinjustiert, bis eine möglichst symmetrische Verteilung vorliegt.

Zur Erzeugung des stabilen Modenpaars muss es sich beim ersten und zweiten optischen Resonator nicht unbedingt um separate Resonatoren handeln, damit die oben genannte Bedingung erfüllt ist. Vielmehr kann der erste und zweite optische Resonator gleichzeitig durch einen einzigen Resonator ausgebildet werden, in dem beide Moden vorhanden sind. Dies ist auch nicht auf einen speziellen Resonatortyp eingeschränkt, insbesondere können auch in diesem Fall als Resonator ein Fabry-Perot-Interferometer bzw. -Resonator oder ein Ringresonator verwendet werden. Daher ist es bei einer bevorzugten Ausführungsform des erfindungsgemäßen Verfahrens vorgesehen, dass der erste Resonator gleichzeitig auch den zweiten Resonator ausbildet und identisch mit diesem ist. Analog ist es bei einer bevorzugten Ausführungsform der erfindungsgemäßen Vorrichtung vorgesehen, dass der erste Resonator gleichzeitig auch den zweiten Resonator ausbildet und identisch mit diesem ist.

Selbstverständlich eignet sich ein solcher erster Resonator, der gleichzeitig auch den zweiten Resonator ausbildet und mit diesem identisch ist, auch zur Herstellung gekoppelter Moden. Beispielsweise kann eine Modenkopplung auf einfache Art und Weise dadurch erfolgen, dass ein teilweise reflektierendes Element in den Strahlengang gestellt wird, wodurch gegenläufige gekoppelte Moden erzeugt werden. D.h. das reflektierende Element reflektiert vorzugsweise nur einen Teil des Lichts und ist für einen Teil des Lichts durchlässig. Insbesondere bei Ringresonatoren kann auf diese Weise ein stabiles Modenpaar erzeugt werden, bei dem die Ausbreitungsrichtung der einen Resonatormode im Uhrzeigersinn und die Ausbreitungsrichtung der anderen Resonatormode gegen den Uhrzeigersinn verläuft. Daher ist es bei einer bevorzugten Ausführungsform des erfindungsgemäßen Verfahrens vorgesehen, dass die Modenkopplung mittels eines zumindest teilweise reflektierenden Elements erzeugt wird. Analog ist es bei einer bevorzugten Ausführungsform der erfindungsgemäßen Vorrichtung vorgesehen, dass ein zumindest teilweise reflektierendes Element vorgesehen ist, um die Modenkopplung zu erzeugen.

Wenn es sich beim ersten und zweiten Resonator um separate Resonatoren handelt, besteht eine Möglichkeit, gekoppelte Moden zu erzeugen, darin, die Resonatoren zu koppeln, wobei die Kopplung beispielsweise evaneszent erfolgen kann. Ringresonatoren bieten sich für eine solche evaneszente besonders an, da auch die Einkopplung des Lichts in solche Resonatoren üblicherweise evaneszent erfolgt. Daher ist es bei einer bevorzugten Ausführungsform des erfindungsgemäßen Verfahrens vorgesehen, dass die Modenkopplung durch evaneszente Kopplung des ersten Resonators mit dem zweiten Resonator erzeugt wird. Analog ist es bei einer bevorzugten Ausführungsform der erfindungsgemäßen Vorrichtung vorgesehen, dass der erste Resonator mit dem zweiten Resonator evaneszent gekoppelt ist, um die Modenkopplung zu erzeugen.

Aufwendige Analysen optischer Resonatoren des Fabry-Perot-Typs haben ergeben, dass bei geschickter Auslegung des Resonators verschiedene räumliche Moden zur Erzeugung eines stabilen Modenpaars verwendet werden können. Dabei kann für Moden mit gleichem longitudinalen Index, aber verschiedenen transversalen Indizes der Frequenzunterschied der Moden, $\Delta f = |f1 - f2|$, äußerst stabil gemacht werden. Die Wahl der Basis zur Beschreibung der Moden mit longitudinalen und transversalen Indizes spielt dabei keine Rolle. Beispielsweise kann die Hermite-Gauß-Basis verwendet werden. Daher ist es bei einer bevorzugten Ausführungsform des erfindungsgemäßen Verfahrens vorgesehen, dass die beiden Resonatormoden durch jeweils einen longitudinalen Index und zwei transversale Indizes beschreibbar sind, wobei die erste Resonatormode und die zweite Resonatormode denselben longitudinalen Index und zumindest einen unterschiedlichen transversalen Index aufweisen. Analog ist es bei einer bevorzugten Ausführungsform der erfindungsgemäßen Vorrichtung vorgesehen, dass die beiden Resonatormoden durch jeweils einen longitudinalen Index und zwei transversale Indizes beschreibbar sind, wobei die erste Resonatormode und die zweite Resonatormode denselben longitudinalen Index und zumindest einen unterschiedlichen transversalen Index aufweisen. Es sei bemerkt, dass bei optischen Resonatoren des Fabry-Perot-Typs neben der Resonatorlänge auch Krümmungsradien von Spiegeln variiert werden können, wobei bei geschickter Auslegung dieser Krümmungsradien die Stabilität der Referenzfrequenz weiter verbessert werden kann.

Grundsätzlich kann durch Regelung des jeweiligen Betriebsparameters, insbesondere durch Temperaturregelung, die jeweilige Resonatorlänge der optischen Resonatoren kontrolliert und damit die Stabilität der Referenzfrequenz $\Delta f$ verbessert werden. Es zeigt sich jedoch, dass die Langzeitstabilität dramatisch verbessert werden kann, indem Licht einer dritten Frequenz f3 erzeugt wird, welche eine größere Abhängigkeit vom Betriebsparameter, insbesondere eine größere Temperaturabhängigkeit, als $\Delta f$ aufweist, und die Differenz dieser dritten Frequenz f3 mit einer der beiden anderen Frequenzen f1 oder f2 als Vergleichsfrequenz f4 verwendet wird. Die größere Abhängigkeit kann mathematisch im Allgemeinen als eine absolut größere erste Ableitung (nach dem jeweiligen Betriebsparameter, insbesondere der Temperatur) oder zumindest als ein absolut größerer Differenzenquotient rund um $BP_0$ angegeben werden.

Indem das Verhältnis oder die Differenz zwischen f4 und $\Delta f$ am Arbeitspunkt (also bei $BP_0$) einmal bestimmt wird, kann durch den anschließenden, fortlaufenden Vergleich von f4 und $\Delta f$ ein Fehlersignal erzeugt werden, dass zur Regelung des Betriebsparameters, insbesondere der Temperatur, beispielsweise mittels einer Heizstromquelle und/oder eines Peltierelements, ausgenutzt werden kann. Aufgrund der höheren Empfindlichkeit von f3 kann dadurch $\Delta f$ wesentlich empfindlicher geregelt, als dies allein anhand $\Delta f$ bzw. f1 und f2 möglich wäre. Daher ist es bei einer bevorzugten Ausführungsform des erfindungsgemäßen Verfahrens vorgesehen, Licht einer dritten Frequenz f3 erzeugt und mittels eines Resonators stabilisiert wird, wobei f3 eine größere Abhängigkeit vom Betriebsparameter, insbesondere von der Temperatur, als $\Delta f$ aufweist, dass eine Vergleichsfrequenz f4 durch f4 = |f3 - f1| oder f4 = |f3 - f2| gegeben ist und dass das Verhältnis f4/$\Delta f$ oder die Differenz f4-$\Delta f$ bestimmt und zur Steuerung von Betriebsparameterregelmitteln, insbesondere Temperaturregelmitteln, welche zur Regelung des Betriebsparameters, insbesondere der Temperatur, des ersten Resonators und/oder zweiten Resonators vorgesehen sind, verwendet wird. Analog ist es bei einer bevorzugten Ausführungsform der erfindungsgemäßen Vorrichtung vorgesehen, dass dritte Lichterzeugungsmittel zur Erzeugung von Licht einer dritten Frequenz f3 vorgesehen sind sowie ein Resonator zur Stabilisierung, wobei f3 eine größere Abhängigkeit vom Betriebsparameter, insbesondere von der Temperatur, als $\Delta f$ aufweist, dass eine Vergleichsfrequenz f4 durch f4 = |f3 - f1| oder f4 = |f3 - f2| gegeben ist, wobei weitere Bestimmungsmittel vorgesehen sind, um das Verhältnis f4/$\Delta f$ oder die Differenz f4-$\Delta f$ zu bestimmen,

und dass Betriebsparameterregelmittel, insbesondere Temperaturregelmittel, vorgesehen sind, um den Betriebsparameter, insbesondere die Temperatur, des ersten Resonators und/oder des zweiten Resonators in Abhängigkeit vom Verhältnis f4/$\Delta f$ oder der Differenz f4-$\Delta f$ zu steuern.

Es sei bemerkt, dass es sich auch beim Licht der Frequenz f3 nicht unbedingt um sichtbares Licht handeln muss, sondern es sich auch um langwelligeres oder kurzwelligeres Licht handeln kann. Insgesamt kann auf diese Weise die Referenzfrequenz langzeitstabilisiert werden, ohne dass eine externe, atomar oder anders erzeugte Rferenz benötigt wird.

Zur Stabilisierung des Lichts der Frequenz f3 können der vorhandene Resonator oder die vorhandenen Resonatoren oder ein zusätzlicher Resonator verwendet werden, sodass sämtlichen denkmöglichen konstruktiven oder herstellungskostenmäßigen Anforderungen Rechnung getragen werden kann. Daher ist es bei einer bevorzugten Ausführungsform des erfindungsgemäßen Verfahrens vorgesehen, dass zur Stabilisierung des Lichts der dritten Frequenz f3 der erste Resonator und/oder der zweite Resonator oder ein dritter Resonator verwendet werden. Analog ist es bei einer bevorzugten Ausführungsform der erfindungsgemäßen Vorrichtung vorgesehen, dass der Resonator zur Stabilisierung des Lichts der dritten Frequenz f3 der erste Resonator und/oder der zweite Resonator oder ein dritter Resonator ist.

Bei einer besonders bevorzugten Ausführungsform des erfindungsgemäßen Verfahrens ist vorgesehen, dass das Licht der dritten Frequenz f3 durch eine Kammmode eines Frequenzkamms ausgebildet wird. Analog ist es bei einer besonders bevorzugten Ausführungsform der erfindungsgemäßen Vorrichtung vorgesehen, dass die dritten Lichterzeugungsmittel einen Frequenzkamm umfassen, um das Licht der dritten Frequenz f3 als Kammmode des Frequenzkamms oder mittels eines Zahnabstands der Kammmoden des Frequenzkamms auszubilden. Die Stabilisierung von f3 kann in diesem Fall durch den ersten und/oder zweiten Resonator erfolgen, indem ein Zahnabstand des Frequenzkamms durch das erhaltene Δf, ggf. multipliziert um einen Faktor, gesetzt wird. Diese Stabilisierung erfolgt also, bevor die Rückkopplungsschleife durch den Vergleich von f4 mit Δf durchgeführt wird. Der Einsatz eines Frequenzkamms hat den Vorteil, dass f3 bequem so groß gewählt werden kann, dass jedenfalls eine deutlich größere Temperaturabhängigkeit für f3 bzw. f4 als für Δf gegeben ist, was für eine entsprechend präzise Langzeitstabilisierung von Δf mittels der oben bereits beschriebenen Temperaturregelung verwendet werden kann. Typischerweise wird bei Anwendungen in der Praxis f3 im Bereich von 100 bis 1000 THz gewählt.

Wie bereits festgehalten, können unterschiedliche Typen von Resonatoren verwendet werden, insbesondere Fabry-Perot-Resonatoren bzw. Interferometer oder Ringresonatoren (auch als Flüstergaliermoden-Resonatoren bezeichnet). Entsprechend ist es bei einer bevorzugten Ausführungsform des erfindungsgemäßen Verfahrens vorgesehen, dass als erster Resonator und/oder als zweiter Resonator ein Fabry-Perot-Resonator verwendet wird. Analog ist es bei einer besonders bevorzugten Ausführungsform der erfindungsgemäßen Vorrichtung vorgesehen, dass es sich bei dem ersten Resonator und/oder dem zweiten Resonator um ein Fabry-Perot-Resonator handelt. Weiters ist es bei einer bevorzugten Ausführungsform des erfindungsgemäßen Verfahrens vorgesehen, dass als erster Resonator und/oder als zweiter Resonator ein optischer Ringresonator verwendet wird. Analog ist es bei einer besonders bevorzugten Ausführungsform der erfindungsgemäßen Vorrichtung vorgesehen, dass es sich bei dem ersten Resonator und/oder dem zweiten Resonator um einen optischen Ringresonator handelt.

Die genannten optischen Resonatoren weisen insbesondere den Vorteil der Miniaturisierbarkeit auf, sodass sie problemlos in photonische Strukturen auf optischen Chips bzw. in massenfabrikationstaugliche Mikrosysteme integrierbar sind. Fabry-Perot-Resonatoren können beispielsweise als Wellenleiter mit integrierten Bragg-Spiegeln realisiert werden. Um Ringresonatoren auszubilden, können geschlossene Wellenleiter verwendet werden, welche zum Beispiel kreisförmig, elliptisch oder stadionförmig sein können, aber prinzipiell jede geschlossene Form annehmen können. Entsprechend ist es bei einer bevorzugten Ausführungsform des erfindungsgemäßen Verfahrens vorgesehen, dass als erster Resonator und/oder als zweiter Resonator ein als Wellenleiter auf einem optischen Chip ausgebildeter optischer Resonator verwendet wird. Analog ist es bei einer besonders bevorzugten Ausführungsform der erfindungsgemäßen Vorrichtung vorgesehen, dass der erste Resonator und/oder der zweite Resonator als Wellenleiter auf einem optischen Chip ausgebildet ist.

KURZE BESCHREIBUNG DER FIGUREN

Die Erfindung wird nun anhand von Ausführungsbeispielen näher erläutert. Die Zeichnungen sind beispielhaft und sollen den Erfindungsgedanken zwar darlegen, ihn aber keinesfalls einengen oder gar abschließend wiedergeben.

Dabei zeigt:

Fig. 1              zeigt eine schematische Darstellung eines optischen Resonators des Fabry-Perot-Typs (auch als "Cavity" bezeichnet)

Fig. 2a             die Veränderung der Frequenzabhängigkeiten mit der Länge L des Resonators aus Fig. 1

Fig. 2b             eine vergrößerte Detailansicht eines Bereichs aus Fig. 2a

Fig. 3              eine schematische Darstellung einer Ausführungsform einer erfindungsgemäßen Vorrichtung zur Erzeugung einer Referenzfrequenz, wobei die Frequenz eines Oszillators auf die Referenzfrequenz stabilisiert wird

Fig. 4              eine schematische Darstellung einer weiteren Ausführungsform der erfindungsgemäßen Vorrichtung, wobei die Länge des Resonators mittels der Temperatur auf das Verhältnis zweier Frequenzunterschiede zwischen drei optischen Moden stabilisiert wird

Fig. 5          eine schematische Darstellung einer weiteren Ausführungsform der erfindungsgemäßen Vorrichtung, in der die Länge des Resonators mittels der Temperatur auf den Unterschied zwischen der optischen Frequenz einer Mode des Resonators und einer Mode eines Frequenzkamms stabilisiert wird, wobei der Zahnabstand im Frequenzkamm durch die Referenzfrequenz bestimmt wird

Fig. 6 a) bis d)    schematische Darstellungen der relevanten Frequenzen für die Anwendung aus Fig. 5

Fig. 7 a) bis d)    den Effekt von Abweichungen von Resonatoreigenschaften von ihren Idealwerten

Fig. 8          eine weitere Ausführungsform der erfindungsgemäßen Vorrichtung, wobei drei Ringresonatoren verwendet werden

Fig. 9          eine weitere Ausführungsform der erfindungsgemäßen Vorrichtung analog zu Fig. 8, wobei jedoch der erste und der zweite Ringresonator gekoppelt sind

Fig. 10a        eine diagrammatische Veranschaulichung der Frequenzen der Moden der einzelnen Ringresonatoren aus Fig. 8 und der gekoppelten Ringresonatoren aus Fig. 9 als Funktion der Temperatur (bezogen auf eine Arbeitspunkttemperatur)

Fig. 10b        eine diagrammatische Veranschaulichung der Referenzfrequenz im Falle der gekoppelten Ringresonatoren aus Fig. 9 als Funktion der Temperatur (bezogen auf eine Arbeitspunkttemperatur)

WEGE ZUR AUSFÜHRUNG DER ERFINDUNG

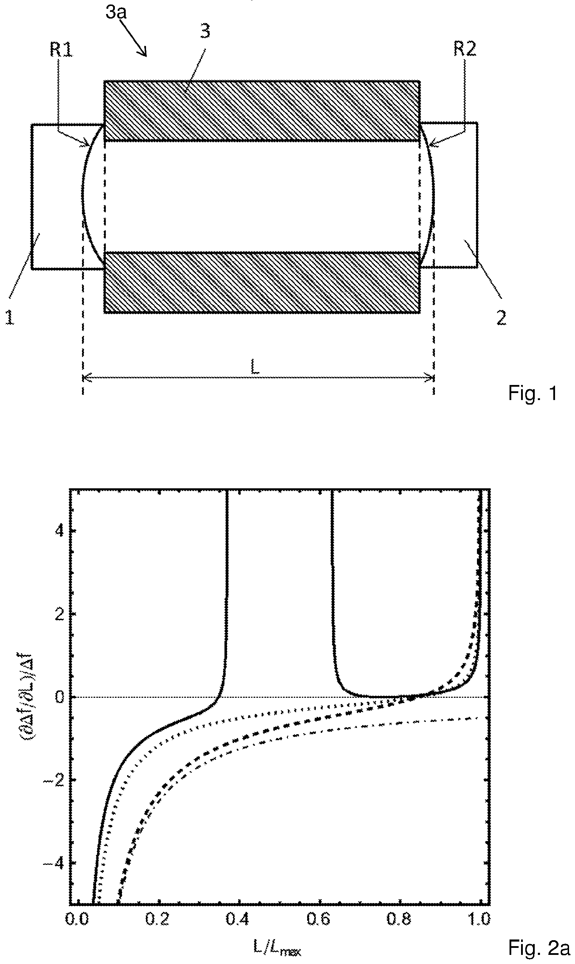

Fig. 1 zeigt eine schematische Darstellung eines Fabry-Perot-Resonators 3a, der erfindungsgemäß zur Erzeugung einer stabilen Referenzfrequenz verwendet werden kann. In einem solchen optischen Resonator 3a ist die Frequenz einer optischen Mode durch Krümmungsradien R1, R2 eines ersten Spiegels 1 und eines zweiten Spiegels 2 sowie durch eine Länge L des Resonators 3a bestimmt. Die Frequenz f einer Mode des Resonators 3a im Vakuum ist

$$f = \frac{c}{2L}\left[ l + \frac{1+m+n}{\pi}\cos^{-1}\left( \sqrt{1 - \frac{L}{R_1}}\sqrt{1 - \frac{L}{R_2}} \right) \right]$$

Die Länge L des Resonators ist durch die Dimension einer Halterung 3 der Spiegel 1, 2 bestimmt. Die Lichtgeschwindigkeit c bestimmt die Umlaufzeit eines Lichtteilchens bzw. Photons im Resonator 3a. Diese Umlaufzeit ist weiters durch die transversalen Modenindizes m und n bedingt, welche Teil der Menge der ganzen, positiven Zahlen inklusive 0 sind. Für die obige Formel wurde die Hermite-Gauß-Basis für die Resonatormoden gewählt. Das hierin dargestellte Prinzip ist aber basisunabhängig und lässt sich ebenso in jeder anderen kompletten Basis beschreiben.
Der longitudinale Modenindex ist durch 1 gegeben, auch Teil der ganzen positiven Zahlen. Der Frequenzunterschied zwischen zwei Moden mit longitudinalen Indizes 11 und 12 und transversalen Indizes m1=m2=n1=n2=0 ist gegeben durch

$$\Delta f(0,0) = \frac{c}{2L}(l_2 - l_1)$$

und ist somit immer von der Länge L des Resonators 3a abhängig. Erfindungsgemäß kann der Frequenzunterschied Δf zwischen zwei Moden mit gleichem longitudinalen Index l, aber verschiedenen transversalen Indizes, zum Beispiel m1=0, n1=0 und m2=1, n2=0, als Referenzfrequenz genutzt werden, da sich diese als extrem stabil erweist, wie im Folgenden noch weiter ausgeführt wird. Der resultierende Frequenzunterschied Δf ist

$$\Delta f = \frac{c}{2L}\frac{m+n}{\pi}\cos^{-1}\left(\sqrt{1-\frac{L}{R_1}}\sqrt{1-\frac{L}{R_2}}\right)$$

Durch das nichtmonotone Verhalten der arccos-Funktion wird es möglich, Kombinationen von L, R1 und R2 zu finden, für welche die Längenabhängigkeit der Frequenz Umkehrpunkte aufweist und sogar erst in der dritten Ordnung vom Referenzwert abweicht.

Diese Tatsache ist in Fig. 2a ersichtlich. Hier wird die erste Ableitung des Frequenzunterschieds bzw. der Referenzfrequenz $\Delta f$ nach der Resonatorlänge L für verschiedene Kombinationen von R1 und R2 gezeigt. Die Resonatorlänge L ist in Fig. 2a für alle Funktionen auf die maximale Länge $L_{max}$=R1+R2 normiert. Die Ableitung ist wiederum auf den lokalen Frequenzunterschied bzw. die lokale Referenzfrequenz $\Delta f$ bei der Länge $L/L_{max}$ normiert. Die in Fig. 2a gezeigten Funktionen entsprechen folgenden Konfigurationen des Resonators 3a: Spiegel 1 flach, Spiegel 2 gekrümmt ("plan-konkav", gestrichelte Linie); Spiegel 1 und Spiegel 2 mit gleichem Krümmungsradius ("symmetrisch", gepunktete Linie); Spiegel 1 mit Krümmungsradius R1, Spiegel 2 mit Krümmungsradius R2=$\Phi$*R1 ("optimal", durchgehende Linie). Der Faktor $\Phi$ wird im Weiteren noch erläutert.

Zum Vergleich wird in Fig. 2a weiters auch das Verhalten der normierten Ableitung für die Frequenz einer einzelnen optischen Mode mit m=n=0 gezeigt (strichpunktierte Linie).

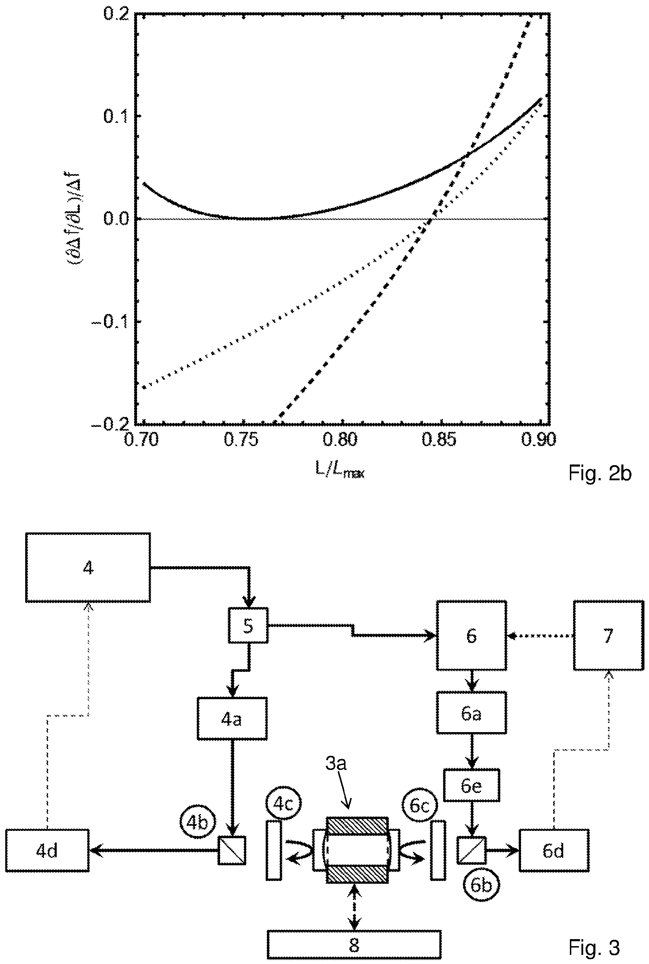

In Fig. 2b wird die Region um $L/L_{max}$~0,8 im Detail gezeigt. Hier ist deutlich sichtbar, dass die Ableitungen sowohl für die symmetrische als auch für die plan-konkave Geometrie einen Nulldurchgang aufweisen, während die Ableitung für den optimalen Fall sogar quadratisches Verhalten aufweist.

Der optimale Fall kann erreicht werden, indem das Verhältnis der Krümmungsradien $\Phi$~1,7048 gesetzt wird. Der stabilste Punkt liegt dann bei einer optimalen Resonatorlänge von $L_{opt}$~2, 0428*R1. Die Größe $L_{opt}$ kann durch Lösen der transzendentalen Gleichung

$$L_{opt} = \frac{\tan L_{opt}}{1 + \tan L_{opt}}$$

gefunden werden. Das optimale Verhältnis $\Phi$ der Krümmungsradien R1, R2 kann damit als

$$\Phi = \frac{L_{opt}(1 - L_{opt})}{1 - L_{opt} - \cos^2 L_{opt}}$$

ausgedrückt werden. Die Nulldurchgangslänge für symmetrische und plan-konkave Resonatoren 3a kann somit durch Lösen der Gleichung

$$\frac{1}{2}\sqrt{\frac{L_x}{1 - L_x}} = \cos^{-1}(1 - L_x)$$

mit $L_x$=$L/L_{max}$, gefunden werden, und liegt bei ~0, 8446*$L_{max}$.

Es sei hier angemerkt, dass alle Resonatoren 3a mit R2/R1<$\Phi$ mindestens einen Nulldurchgang in der ersten Ableitung haben. Bei günstigen Kombinationen von Radien R1, R2 und Länge L kann also ein stabiler Frequenzunterschied $\Delta f$ zwischen ausgewählten Moden gemessen werden. Ein solcher Resonator 3a kann also als Frequenzreferenz dienen, welche zum Beispiel gegen durch Vibrationen verursachte Längenveränderungen unempfindlich ist.

Faktoren, welche sowohl die Länge L als auch die Krümmungsradien R1, R2 der Spiegel 1, 2 beeinflussen, haben einen merklicheren Effekt auf die Referenzfrequenz $\Delta f$. Insbesondere im Vakuum ist der wichtigste Faktor die Temperatur. Diese kann durch Erweiterung des Ausdrucks für den Frequenzunterschied,

$$\Delta f(T) = \frac{c}{2L(T)} \frac{m+n}{\pi} \cos^{-1}\left( \sqrt{1 - \frac{L(T)}{R_1(T)}} \sqrt{1 - \frac{L(T)}{R_2(T)}} \right)$$

Mit

$$L(T) = L(1 + \alpha_{S,1} T + \frac{1}{2} \alpha_{S,2}^2 T^2)$$

und

$$R_q(T) = R_q(1 + \alpha_{R_q,1} T + \frac{1}{2} \alpha_{R_q,2}^2 T^2)$$

(mit q=1 oder q=2) eingeführt werden. Hier wurden nur lineare und quadratische Terme der Temperaturabhängigkeit angeführt, welche in praktisch allen Fällen dominant sind. Dabei sind $\alpha_{S,1}$ und $\alpha_{S,2}$ der lineare und der quadratische Expansionskoeffizient der Halterung, während $\alpha_{R_q,1}$ und $\alpha_{R_q,2}$ die Expansionskoeffizienten der Spiegel sind. T bezeichnet den Temperaturunterschied zu einer Arbeitspunkttemperatur, bei welcher die Länge L vorliegt.

Im Weiteren wird der Einfachheit halber angenommen, dass die zwei Spiegel 1, 2 aus dem gleichen Material bestehen, sodass $\alpha_{R_1,1} = \alpha_{R_2,1} = \alpha_{R,1}$ und $\alpha_{R_1,2} = \alpha_{R_2,2} = \alpha_{R,2}$ gilt. Es sei an dieser Stelle angemerkt, dass die Temperaturabhängigkeit durch eine geeignete Wahl von verschiedenen Koeffizienten - z.B. durch Auswahl verschiedener Materialien - für die zwei Spiegel 1, 2 noch weiter verringert werden kann.

Da, wie oben erläutert, kleine Längenänderungen vernachlässigbar sind, verändert sich die Referenzfrequenz $\Delta f(T)$ hauptsächlich aufgrund der thermischen Ausdehnung der Spiegel 1, 2. Die Spiegel 1, 2 können aus einem Material bestehen, welches bei einer gewissen Temperatur, vorzugsweise der Arbeitspunkttemperatur, einen Nulldurchgang des linearen Temperaturkoeffizienten aufweist, d.h. $\alpha_{R,1}$ = 0, sodass nur eine quadratische Temperaturabhängigkeit vorhanden ist. Diese Materialien werden in der Optik routinemäßig eingesetzt, wie zum Beispiel ULE® Glas bei Raumtemperatur oder Silizium bei 124K.

Wenn aber die Halterung 3 aus einem Material mit nicht verschwindendem linearen thermischen Koeffizienten besteht, wird der Frequenzunterschied zwischen transversalen Grundmoden $\Delta f(T,0,0)$ sowie deren optische Frequenzen eine dementsprechende thermische Abhängigkeit aufweisen.

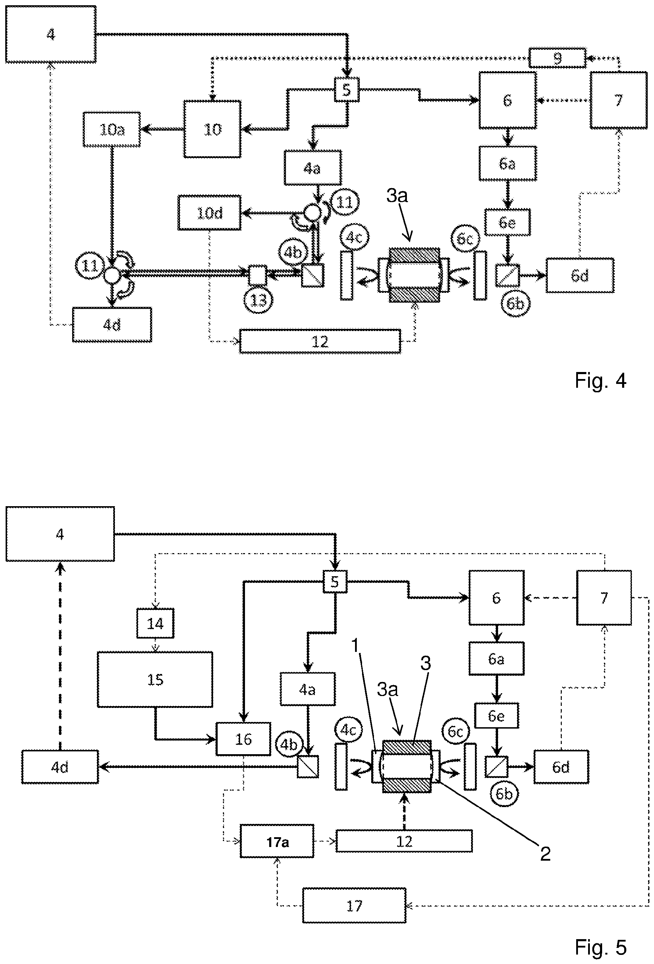

Diese Empfindlichkeit wird in den unten beschriebenen Ausführungsbeispielen aus Fig. 4 und Fig. 5 zur Selbststabilisierung des Resonators verwendet.

Im der obigen Beschreibung wurde durchgehend angenommen, dass sich der optische Resonator 3a in einem evakuierten Behälter befindet. Die Erfindung kann jedoch auch in einem lichtdurchlässigen Medium wie Luft funktionsfähig gemacht werden. Hierfür muss die Abhängigkeit der Lichtgeschwindigkeit vom Brechungsindex und dessen Abhängigkeit von Druck P, Temperatur T und anderen Umwelteinflüssen X, in allen Formeln mittels der Substitution c→c/n(T,P,X) eingebracht werden. In dieser Erweiterung können Umwelteinflüsse, welche von der Temperatur abhängen, wie zum Beispiel der Druck P in einem luftdichten Resonator 3a, durch leichte Abänderung der Parameter ausgeglichen werden. Temperaturunabhängige Parameter, z.B. eine Kontamination des Mediums, können nicht ausgeglichen werden und führen zu einem Frequenzschub.

Fig. 3 zeigt schematisch ein Ausführungsbeispiel einer erfindungsgemäßen Vorrichtung zur Erzeugung der Referenzfrequenz $\Delta f$, wobei die Frequenz eines regelbaren Oszillators 7 auf die Referenzfrequenz $\Delta f$ stabilisiert wird. Ein Laser 4 erzeugt eine linear polarisierte optische Welle mit geringer Frequenzbreite. Diese wird zu einem elektrooptischen Modulator 4a geleitet, welcher Seitenbänder auf der optischen Welle erzeugt. Die modulierte optische Welle wird über einen polarisierenden Strahlteiler 4b und eine Viertelwellenretardationsoptik 4c zum optischen Resonator geleitet. Letzterer ist in Fig. 3 - und auch in Fig. 4 und Fig. 5 - wieder als Fabry-Perot-Resonator 3a dargestellt, es könnte jedoch grundsätzlich auch ein anderer Resonatortyp, insbesondere auch ein Ringresonator, verwendet werden.

Die Polarisationsoptiken 4b und 4c sorgen dafür, dass das vom Resonator 3a reflektierte Licht den Strahlteiler 4b in Richtung eines Demodulators 4d verlässt. Die Seitenbänder ermöglichen es, mittels des Demodulators 4d ein Fehlersignal zu erzeugen, anhand dessen die Laserfrequenz an die Frequenz f1 einer ersten Resonatormode, die eine transversale Grundmode M1 (mit Modenindizes 11, m1=0, n1=0) des optischen Resonators 3a ist, stabilisert werden kann, was durch den strichlierten, zum Laser 4 weisenden Pfeil in Fig. 3 angedeutet ist. Dieses Stabilisierungsverfahren ist als Pound-Drever-Hall-Verfahren bekannt, vgl. Ref. 6 [Drever, R. W. P., Hall, J. L., Kowalski, F. V., Hough, J., Ford, G. M., Munley, A. J., & Ward, H.; "Laser phase and frequency stabilization using an optical resonator"; Applied Physics B, 31(2), 97-105 (1983)].

Ein Teil des Laserstrahls des Lasers 4 wird mittels eines Strahlteilers 5 nun zu einem akustooptischen Frequenzschieber 6 geführt. Dieser Strahl wird durch einen zweiten elektrooptischen Modulator 6a geführt und wird durch einen zweiten polarisierenden Strahlteiler 6b und eine zweite Viertelwellenretardationsoptik 6c zum optischen Resonator 3a geleitet. Ziel dieses zweiten Strahlgangs ist es, eine zweite Resonatormode in Form einer höheren transversalen Mode M2 mit demselben longitudinalen Index $l2=l1$ (zum Beispiel mit Indizes m2=1, n2=0) und der Frequenz f2 anzuregen. Dazu muss das Strahlprofil an das der erwünschten zweiten Resonatormode angepasst werden. Dies kann beispielsweise durch eine strukturierte Phasenplatte 6e erzielt werden, wie es oft in der Optik und Quantenoptik geschieht.

Auch dieser Strahl wird nach dessen Wiederaustritt bzw. Reflexion durch den Resonator 3a durch die Polarisationsoptiken 6b, 6c zu einem zweiten Demodulator 6d geführt. Der zweite elektrooptische Modulator 6a kann bei einer anderen Frequenz als der elektrooptische Modulator 4a betrieben werden, um saubere Demodulation am zweiten Demodulator 6d zu ermöglichen. Das Fehlersignal wird hier direkt durch das Pound-Drever-Hall-Verfahren ermittelt: Die Frequenz f2 ist durch $f1+\Delta f$ gegeben. Der Laserstrahl hat aber die Frequenz f1+f(7), wo f(7) die Frequenz des Oszillators 7 ist. Wenn $f(7) \neq \Delta f$, dann wird die Pound-Drever-Hall-Messung ein Fehlersignal ausgeben. Das Fehlersignal entsteht also durch den Unterschied zwischen f1+f(7) und f2. Kürzer ausgedrückt kann man daher sagen, dass das resultierende Fehlersignal dem Unterschied zwischen der Oszillatorfrequenz f(7) und $\Delta f$ entspricht und die Frequenz f(7) des Oszillators 7 an den Frequenzunterschied zwischen den zwei angeregten Moden des Resonators 3a, also an die Referenzfrequenz $\Delta f$, stabilisiert wird.

Ein Temperaturregler 8 kann die ohnehin schon geringe Empfindlichkeit des Aufbaus noch weiter minimieren. Solche Regler sind für eine Stabilisierung bis zu Schwankungen um $10^{-3}$ K kommerziell erhältlich.

Der Resonator 3a selbst kann verwendet werden, um eine noch höhere Frequenzgenauigkeit bzw. Stabilität der Referenzfrequenz $\Delta f$ zu erzielen. Ein Beispiel eines solchen Systems ist im Ausführungsbeispiel der Fig. 4 gezeigt. Hier wird vom Strahlteiler 5 ein weiterer Teilstrahl zu einem weiteren akustooptischen Modulator 10 geführt. Dieser wird mit einer Frequenz betrieben, die mittels eines geeigneten, fixen Frequenzmultiplikators 9, der die eingehende Frequenz um einen Faktor $a_f$ vervielfacht, direkt vom Oszillator 7 erzeugt wird. Der akustooptische Modulator 10 erzeugt dadurch einen Strahl, welcher am erwünschten Arbeitspunkt genau mit einer weiteren longitudinalen, dritten Resonatormode M3 (mit Indizes $l3 \neq l1$, n=0, m=0) mit einer Frequenz f3 resonant ist. Mittels eines weiteren elektrooptischen Modulators 10a, der dem akustooptischen Modulator 10 nachgeschaltet ist, werden Seitenbänder auf der optischen Welle erzeugt - analog zur oben geschilderten Funktion des elektrooptischen Modulators 4a.

Da der Frequenzabstand f4 zwischen der Frequenz f3 dieser dritten Resonatormode und der Laserfrequenz bzw. der Frequenz f1 der ersten Resonatormode eine weitaus stärkere Temperaturabhängigkeit hat als der Frequenzabstand $\Delta f$ der zweiten Frequenz f2 der höheren transversalen Mode M2 von der Laserfrequenz f1, wird eine Temperaturabweichung dazu führen, dass die Resonanzbedingung für f3 nicht mehr erfüllt ist. Diese Abweichung wird durch einen dritten Demodulator 10d erfasst. Ähnlich wie oben geschildert kann das Fehlersignal ermittelt werden als Unterschied zwischen $f1+\Delta f*a_f$ und f3. Hier ist f3 die Frequenz der Resonatormode M3 beim Sollwert der Temperatur. Kürzer ausgedrückt entspricht das Fehlersignal also dem Unterschied zwischen f4 und $\Delta f*a_f$. Das Fehlersignal kann nun an eine Heizstromquelle 12 geleitet werden, um diese zu steuern.

In dem gezeigten Beispiel werden optische Zirkulatoren 11 und eine weitere Polarisationsoptik 13 dazu verwendet, um die verschiedenen Strahlen an die gewünschten Demodulatoren 4d, 10d zu führen. Die absolute Frequenzabweichung f4 ist proportional zum Unterschied der longitudinalen Indizes $l3-l1$. Dieser Unterschied ist im angeführten Beispiel durch die Modulationsfrequenz des akustooptischen Modulators 10 auf etwa 1 GHz begrenzt, kann aber in anderen Ausführungen um Größenordnungen höher sein. Letzteres kann beispielsweise dadurch erzielt werden, indem die verschiedenen Lichtfrequenzen f1, f3 und ggf. f2 von verschiedenen Laserquellen erzeugt werden.

In der Praxis kann der Modenindex $l1$ eine Zahl im Bereich von etwa $10^1$ bis $10^5$ sein, da die optische Wellenlänge größenordnungsmäßig $\sim 1\ \mu m$ beträgt. Die Frequenz f1 beträgt dadurch einige 100 THz. Diese Frequenz f1 ist deutlich größer als $\Delta f$ und f4. Um auch f4 entsprechend so groß zu wählen und damit eine wesentlich genauere Selbststabilisierung des Resonators 3a zu ermöglichen, kann ein optischer Frequenzkamm 15 verwendet werden, vgl. Fig. 5.

In diesem Ausführungsbeispiel sind die Moden des Frequenzkamms 15 direkt ganzzahlig proportional zu der von einem geeigneten, fixen Frequenzteiler 14 gelieferten Frequenz. Solch ein Frequenzkamm 15 ist kommerziell erhältlich. Im Ausführungsbeispiel der Fig. 5 wird die Frequenz des Oszillators 7 über den Frequenzteiler 14 an den Frequenzkamm 15 geleitet und setzt dort den Zahnabstand zwischen den Kammmoden. Ein Teil des Laserlichts wird nun von der Strahlteileroptik 5 zu einer Fotodiode 16 geführt, auf die auch Licht vom Frequenzkamm 15 trifft. Hier entstehen Schwebungsfrequenzen durch das Mischen der optischen Frequenzen von Frequenzkamm 15 und Laser 4. Eine dieser Schwebungen kann mithilfe eines geeigneten Filters isoliert werden. An einem Frequenzkomparator 17a (für gewöhnlich eine Phasenregelschleife) kann diese Schwebungsfrequenz mit der des stabilisierten Oszillators 7 verglichen werden. Dazu muss die Frequenz des stabilisierten Oszillators 7 im Allgemeinen wieder durch einen fixen weiteren Frequenzmultiplikator 17 an die Schwebungsfrequenz beim gewünschten Arbeitspunkt angeglichen werden. Das resultierende Abweichungssignal kann - wie im vorherigen Ausführungsbeispiel der Fig. 4 - an eine Heizstromquelle 12 geleitet werden, um die Länge des Resonators 3a mit hoher Genauigkeit zu stabilisieren.

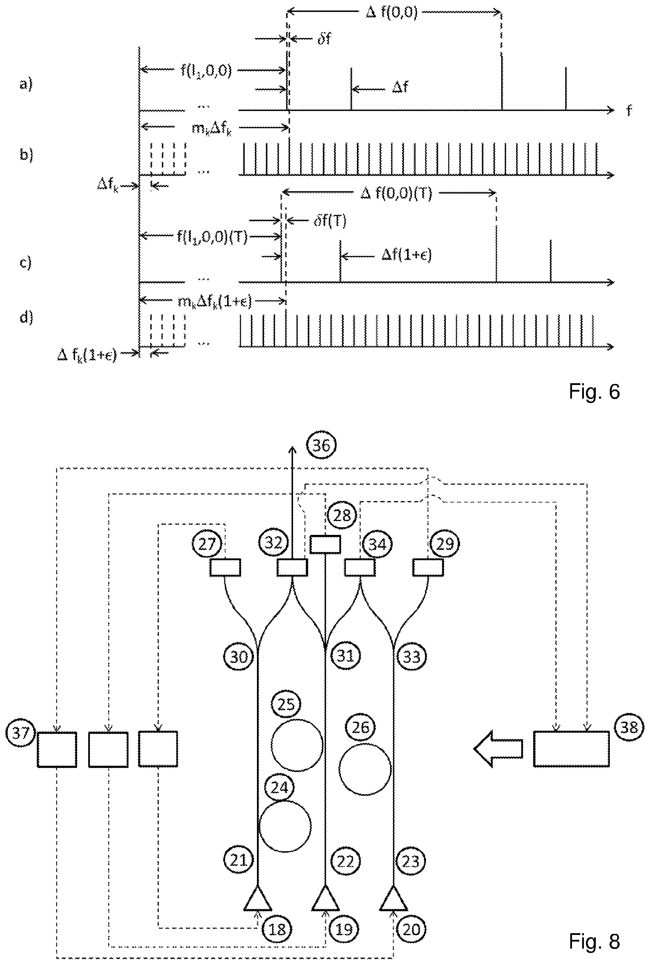

Der Effekt einer Temperaturänderung wird in Fig. 6 gezeigt. Hier zeigen Zeilen a) und b) die Moden des optischen Resonators 3a bei der Solltemperatur, während der Effekt der Temperaturänderung in Zeilen c) und d) dargestellt ist. Eine Temperaturänderung verändert die optische Frequenz f1 der transversalen Grundmode, $f(l1,0,0) \rightarrow f(l1,0,0)(T)$, den Frequenzunterschied von dieser Mode zur nächsten transversalen Grundmode, $\Delta f(0,0) \rightarrow \Delta f(0,0)(T)$, sowie auch die Referenzfrequenz $\Delta f \rightarrow \Delta f \times (1+\epsilon)$. Allerdings ist die relative Änderung der Referenzfrequenz $\epsilon$ wesentlich kleiner als die relative Änderung der beiden anderen genannten Frequenzen. Für die Anwendung aus Fig. 4 bedeutet dies, dass während sich die Temperatur kaum auf die Referenzfrequenz $\Delta f$ auswirkt, sie eine deutlich messbare Auswirkung auf das Verhältnis der zwei Frequenzen hat, anders gesagt ist

$$\mathbf{1 + \epsilon \cong 1,} \ \text{aber} \ \left| \frac{\Delta f(0,0)}{\Delta f} - \frac{\Delta f(0,0)(T)}{\Delta f(1+\epsilon)} \right| \gg \mathbf{0}.$$

In der Anwendung aus Fig. 5 wird die Änderung der Referenzfrequenz multiplikativ auf den Zahnabstand des Frequenzkamms 15 übertragen. Die ursprüngliche Vergleichsmode des Frequenzkamms 15 mit Kammmodenindex $m_k$ und Modenabstand $\Delta f_k$ hat eine Frequenz $m_k \times \Delta f_k$ und wird durch eine Temperatur- oder Längenänderung zur Frequenz $m_k \times \Delta f_k \times (1 + \varepsilon)$ verschoben. Der ursprüngliche Abstand der ausgewählten transversalen Grundmode des Resonators 3a zur nächstgelegenen Kammmode $\delta f = f(l1,0,0) - m_k \times \Delta f_k$ ändert sich dadurch zu $\delta f(T) = f(l1,0,0)(T) - m_k \times \Delta f_k \times (1 + \varepsilon)$. Auch hier bleibt die Referenzfrequenz ihrem Ursprungswert nahe, während ein messbarer Schub des Frequenzabstands $|\delta f(T) - \delta f| \gg 0$ entstehen kann.

D.h. f1 ist von der Frequenz der Mode m1 gegeben, an welche der Laser 4 angeglichen wird; f2 ist von der Frequenz einer höheren transversalen Mode m2 gegeben, an welche die Frequenz des Lasers 4 zuzüglich der Frequenz des akustooptischen Frequenzschiebers 6, angeglichen wird; f3 ist die Frequenz der Kammmode in der Nähe von f1, gegeben von $m_k \times \Delta f_k$; f4 ist der Frequenzunterschied f3-f1.

Die Selbstregulierungsstrategien werden nun anhand eines numerischen Beispiels weiter erläutert.

Die Genauigkeit der Stabilisierung hängt von dem Frequenzauflösungsvermögen des Systems ab. Allgemein kann die Resonanzfrequenz einer Mode in einem optischen Resonator 3a mit einer Genauigkeit von

$$\sigma_f = \frac{c}{2L} \frac{1}{4F} \sqrt{\frac{\hbar c}{\lambda P}} \frac{1}{\sqrt{t}}.$$

bestimmt werden. Hier ist t die Messdauer, h die reduzierte Planck-Konstante, $\lambda$ die Wellenlänge und P die optische Leistung. F gibt die Finesse des Resonators an, welche durch die Qualität der Spiegel gegeben ist.

Realistische Werte dieser Parameter sind P=100 $\mu$W und F=100000. Eine höhere optische Leistung kann zwar die Frequenzauflösung verbessern, führt aber bei zu großen Werten zur Erwärmung der Spiegel durch Absorption. Dieser Effekt ist bei 100 $\mu$W vernachlässigbar. Für die folgenden numerischen Beispiele wird $\lambda$=1,55 $\mu$m gewählt da dies eine gängige Wellenlänge in der optischen Telekommunikation ist. Es wird außerdem angenommen, dass der Resonator - wie in Ref. 3 [Hagemann, C., et al; "Ultrastable laser with average fractional frequency drift rate below 5x 10- 19/s"; Optics Letters (39) 17, 5102-5105 (2014)] - eine Länge von L=21 cm hat. Für eine Messdauer von einer Sekunde kann somit eine Frequenzauflösung von $\sigma_f(min)$=0,064 mHz erreicht werden. Die Auflösung für den Unterschied zwischen zwei Frequenzen kann dann mit $\delta f(min) = \sigma f(min) \times \sqrt{2}$=0.09 mHz geschätzt werden.

Im Ausführungsbeispiel der Fig. 5 besteht die Halterung 3 beispielsweise aus Aluminium, mit einem linearen Ausdehnungskoeffizienten von 23 ppm/K, während die Spiegel 1, 2 beispielsweise aus ULE® Glas sind. Der Resonator 3a befindet sich bei der Nulldurchgangstemperatur des linearen Ausdehnungskoeffizienten der Spiegel (~22°C) und in Vakuum. Die Spiegel 1, 2 haben die oben beschriebenen Krümmungsradien R2=$\Phi$R1 und R1=L/L$_{opt}$. Wenn die Methode aus Fig. 4 angewendet wird und 12-11=1 gilt, dann ergibt sich ein Frequenzunterschied von $\Delta f(0,0)$=714 MHz zwischen zwei benachbarten longitudinalen Grundmoden, während der Unterschied zwischen der ersten longitudinalen Grundmode und der ersten transversalen Mode $\Delta f$=464MHz beträgt. Damit enspricht die kombinierte Frequenzauflösung einer Temperaturänderung von etwa 10 nK. Dies wiederum entspricht einer relativen Frequenzänderung der Referenzfrequenz von $2 \times 10^{-25}$ pro Sekunde, was die derzeitige Bestmarke von Ref. 3 um 6 Größenordnungen unterschreitet. Die relative Längenänderung des Resonators 3a beträgt in diesem Beispiel $2,3 \times 10^{-13}$, und dieser Wert ist um 3 Größenordnungen höher als die derzeit kleinsten thermischen Längenfluktuationen aus Ref. 3.

Hierzu sei noch folgendes bemerkt: Wenn der Wert von $10^{-16}$ aus Ref. 3 als kleinstmöglicher Wert für thermische Längenfluktuationen angenommen wird, dann beträgt die einer solchen Längenänderung entsprechenden Frequenzverschiebung, welche mittels der Methode aus Fig. 5 mit Frequenzkammstabilisierung gemessen wird, immer noch 19,5 mHz. Die Änderung wäre also mit den angenommenen Werten auflösbar und somit regelbar. In diesem Fall würde die relative Änderung der Referenzfrequenz weniger als $10^{-31}$ betragen. Es sei an dieser Stelle auch unterstrichen, dass Langzeitverschiebungen, wie sie in Ref. 3 beschrieben werden, durch die vorgestellte Selbstkorrektur weitestgehend unterbunden werden.

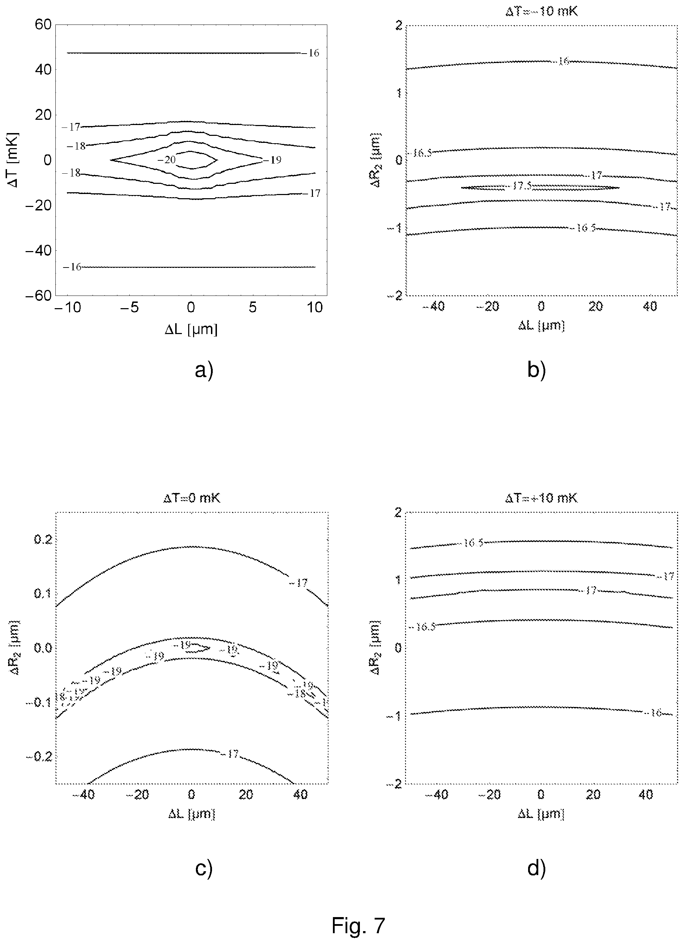

Die oben angeführten Berechnungen gehen von optimalen Werten aus. Die Abbildungen in Fig. 7 zeigen den Effekt von Abweichungen von den optimalen Parametern. Es werden große Schwankungen von 1 $\mu$K in der Temperatur und 1 pm in der Länge des Resonators 3a angenommen, um deren Effekte zu veranschaulichen. Die Konturen zeigen die Größenordnung des Absolutwerts der mittleren relativen Abweichung von $\Delta f$, welche aus diesen Schwankungen der Länge und Temperatur resultiert. Nicht alle Konturen sind gezeigt. Fig. 7 a) zeigt den Effekt von Abweichungen der Temperatur ($\Delta T$) und der Länge ($\Delta L$) von ihren Idealwerten rund um den Arbeitspunkt. Hier wird ersichtlich, dass die angenommenen Schwankungen bei den Idealwerten einen sehr kleinen Effekt haben. Bei Abweichungen von den Idealwerten nimmt der Effekt zu, allerdings wird für steigende Temperaturabweichungen die Bedeutung von Längenabweichungen zunehmend geringer.

Fig. 7 b), c) und d) zeigen den Effekt von Abweichungen in Länge und Krümmungsradius eines Spiegels für drei verschiedene Temperaturabweichungen. Hier ist wieder ersichtlich, dass kleine Längenabweichungen einen geringen Effekt haben, das System aber relativ empfindlich auf Abweichungen im Krümmungsradius ist. Dennoch kann durch eine Anpassung der Temperatur auch ein nichtidealer Resonator 3a schwankungsrobust gemacht werden. Zum Vergleich würde bei den genannten Schwankungsbreiten die Frequenz der optischen Mode eines Resonators 3a, welcher zur Gänze aus ULE® Glas besteht, Werte in der Größenordnung von $10^{-21}$ durch Temperaturschwankung und $10^{-13}$ durch Längenschwankungen aufweisen.

Die Methoden zur Selbststabilisierung können natürlich auch für nichtideale optische Resonatoren verwendet werden, wobei die Referenzfrequenz $\Delta f$ allerdings nicht die bestmögliche Stabilität aufweisen wird.

Abschließend werden nun Ausführungsbeispiele vorgestellt, die problemlos in massenfabrikationstaugliche Mikrosysteme integrierbar sind. Moderne Kommunikations- und Datenverarbeitungssysteme beinhalten zunehmend photonische Komponenten, welche aus optischen Wellenleitern auf Chips bestehen. Ein optischer Wellenleiter ist im Allgemeinen eine Struktur welche aus einem Kern mit einem höheren Brechungsindex als den ihn umgebenden Medien besteht. Dadurch hat Licht propagierende Moden im Wellenleiter, was grob durch ein Bild der totalen internen Reflexion verstanden werden kann. Mittlerweile wurden eine Vielzahl von Chip-integrierten Laserquellen, Modulatoren und Detektoren entwickelt. Mit diesen Komponenten können Chip-basierte optische Resonatoren in einem vollständig integrierten photonischen System als Frequenzreferenzen verwendet werden bzw. kann so eine stabile Referenzfrequenz $\Delta f$ erfindungsgemäß erzeugt werden.

Dabei existieren verschiedene Arten von Chip-basierten Resonatoren. Es ist zum Beispiel möglich, die oben beschriebenen Methoden auch für Wellenleitergeometrien mit integrierten Bragg-Spiegeln zu modifizieren, womit letztlich ein Resonator erzeugt wird, der dem Fabry-Perot-Typ entspricht. Eine weitere mögliche Art von Wellenleiterresonator ist der Flüstergaleriemoden-Resonator, auch Ringresonator genannt, welcher für die Anwendung sehr attraktiv ist da er sehr hohe Güten aufweisen kann, vgl. z.B. Ref. 4 [D. T. Spencer, J. F. Bauters, M. J. R. Heck, and J. E. Bowers; "Integrated waveguide coupled Si3N4 resonators in the ultrahigh-Q regime"; Optica, Vol. 1, No. 3, p. 153, September 20, (2014)]. Diese Art von Resonator besteht im Allgemeinen aus einem geschlossenen Wellenleiter, welcher zum Beispiel kreisförmig, elliptisch oder stadionförmig sein kann, aber prinzipiell jede geschlossene Form annehmen kann. In den folgenden Ausführungsbeispielen werden der Einfachheit halber kreisförmige Resonatoren angenommen, die Beschreibung ist jedoch durch Ersetzen der Resonatorlänge auf jede gewünschte Geometrie anwendbar.

Licht wird mittels evaneszenter Kopplung in die Ringresonatoren ein- und ausgeführt. Die Resonanzfrequenzen können durch den Umfang und den effektiven Brechungsindex der propagierenden Mode berechnet werden. Für diese Systeme sind allerdings keine analytischen Methoden vorhanden, um das Modenspektrum zu berechnen. Daher müssen numerische Minimierungsverfahren angewendet werden. Trotzdem können auch hier Bereiche gefunden werden, für die die Frequenzdifferenz zwischen zwei Moden minimal von der Temperatur abhängt.

Die Lichtmoden eines Wellenleiters haben einen Anteil in den den Kern umgebende Medien, und dieser Anteil ist modenabhängig. Die Tatsache, dass auch hier stabile Modenpaare existieren können, rührt daher, dass verschiedene Moden dadurch verschiedene effektive Brechungsindizes haben, welche auch verschiedene Temperaturabhängigkeiten aufweisen. Daher lassen sich auch hier Modenpaare erzeugen, für die die Änderung der Resonanzfrequenzen für kleine Betriesparameterschwankungen, insbesondere Temperaturschwankungen, nahezu identisch ist.

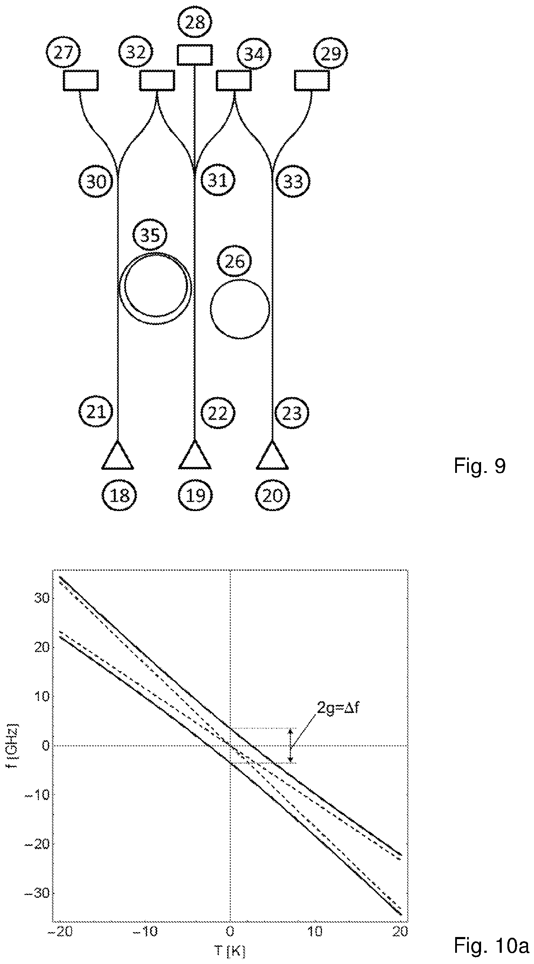

Die Modenpaare können in mehreren Wellenleiteranordnungen erzeugt werden. Zum Beispiel können alle drei benötigten Moden in einem einzigen Ringresonator erzeugt werden (nicht dargestellt). Alternativ dazu können sich die Moden in drei verschiedenen Resonatoren 24, 25, 26 befinden, wodurch sich größere Freiheiten beim Bestimmen der Modeneigenschaften ergeben, vgl. Fig. 8. Eine weitere Variante ist die Erzeugung eines Paares 35 von Ringresonatoren, welche untereinander gekoppelt sind, vgl. Fig. 9. Durch die Kopplung wird ein Modenpaar erzeugt, dessen Frequenzabstand durch die Fabrikationsparameter (Radien und Abstand zwischen den Ringen) fein abgestimmt werden kann, vgl z.B. Ref. 5 [Zhang, Z., Dainese, M., Wosinski, L., & Qiu, M.; "Resonance-splitting and enhanced notch depth in SOI ring resonators with mutual mode coupling"; Optics Express, 16(7), 4621-4630 (2008)].

Die Resonanzfrequenz in einem kreisförmigen Resonator ist gegeben durch

$$f_r(T) = \frac{mc}{2\pi r n(1+\beta T)} \sim \frac{mc}{2\pi r n}(1-\beta T).$$

Hier ist m die Anzahl der Wellenlängen im Resonator, n ist der Brechungsindex und $\beta$ der lineare Temperaturkoeffizient. Der Wert T gibt wieder die Abweichung der Temperatur vom erwünschten Sollwert bzw. der Arbeitspunkttemperatur. Es werden kleine Temperaturänderungen angenommen, sodass quadratische Abweichungen vernachlässigt werden können. Der Temperaturkoeffizient $\beta$ beschreibt dann alle Effekte, die die Propagation der Mode beeinflussen. Diese sind beispielsweise die thermische Ausdehnung, welche den Radius r des Rings und die Dimensionen des Wellenleiters beeinflusst, und die thermische Abhängigkeit des Brechungsindizes n von Kern und Mantel. Im Allgemeinen ist die dimensionale Abhängigkeit für alle Moden gleich sein, die Änderung der Brechungssindizes n jeder Mode ist jedoch unterschiedlich. Dadurch ergibt sich für jede Mode ein leicht unterschiedlicher Koeffizient $\beta$. Der Frequenzunterschied zwischen zwei Moden ist dann gegeben durch

$$\Delta f_r(T) = \frac{c}{2\pi}\left(\frac{m_2(1-\beta_2 T)}{r_2 n_2} - \frac{m_1(1-\beta_1 T)}{r_1 n_1}\right),$$

worin die Indizes 1 und 2 die jeweilige Mode darstellen. Durch obigen Ausdruck wird der Nulldurchgang der ersten Ableitung mit der Bedingung $m_2\beta_2 r_1 n_1 = m_1\beta_1 r_2 n_2$ gefunden. Durch diese zwei Ausdrücke kann das notwendige Verhältnis zwischen Modenindizes, Radien und Brechungsindizes, sowie deren thermischen Abhängigkeiten gefunden werden. Aufwendige Untersuchungen haben ergeben, dass diese Bedingung etwas relaxiert werden kann, um zufriedenstellende Ergebnisse zu erreichen, nämlich auf die Auslegungsbedingung

$$m_1 * \beta_1 * L_2 * n_2 \ = \ m_2 * \beta_2 * L_1 * n_1 \ \pm \ 0,1\%.$$

Das Verhältnis zwischen Modenindizes und Radien ist durch die Lichtfrequenz eingeschränkt, welche beispielsweise für Telekommunikationsanwendungen im Bereich um 195THz liegt. Zudem muss für eine gegebene Wellenleitertechnologie auf die Abhängigkeit der Verluste vom Resonatorradius Rücksicht genommen werden, sodass die Wahl der Radien eingeschränkt werden kann. Dies deswegen, da die Wellenleiter endliche Transmission haben. Je länger der Wellenleiter, desto mehr Licht wird verloren. Umgekehrt gilt aber, dass kleinere Ringradien wegen der stärkeren Krümmung auch zu Verlusten führen. Dadurch ergibt sich ein Bereich von besonders brauchbaren Radien.

Des Weiteren hängen sowohl die Brechungsindizes $n_1$, $n_2$ wie auch die thermischen Koeffizienten $\beta_1$, $\beta_2$ von den Wellenleiterdimensionen ab, und müssen daher gemeinsam auf den Zielwert optimiert werden. Prinzipiell kann also ein gewünschter Frequenzunterschied und eine sinnvolle Größeneinschränkung für die Radien $r_1$, $r_2$ gewählt werden. Zusammen mit dem erzielbaren Bereich der Brechungsindizes $n_1$, $n_2$ ergeben sich dadurch Grenzen für die wählbaren Modenindizes. Danach können die Brechungsindizes $n_1$, $n_2$ und Temperaturkoeffizienten $\beta_1$, $\beta_2$ für den gewünschten Frequenzunterschied $\Delta f$ gewählt werden. Aus Ref. 4 ist beispielsweise ersichtlich, dass Unterschiede im Brechungsindex zwischen ~0% und ~0,15% mittels Dimensionierung des Wellenleiters durchaus erreichbar sind. Der größte dementsprechende Unterschied zwischen den Temperaturabhängigkeiten zweier Moden lässt sich zu ~0,8% berechnen. Für Moden in einem einzelnen Ring ($r_1 = r_2$) ergeben sich daraus stabile Modenpaare mit einem kleinsten Frequenzunterschied von ~11 GHz bei einem Radius von 5mm. Der Frequenzunterschied kann durch den Radius fein abgestimmt werden. Bei zwei verschiedenen Ringen kann der Frequenzunterschied durch die unterschiedlichen Radien feiner und freier abgestimmt werden. Die stabile Frequenz ist sowohl für einen wie auch für zwei Ringe äußerst empfindlich auf die Radien der Ringe. So kann eine Abweichung im Radius um 0,02 Promille eine Abweichung von bis zu zwei Prozent in der Frequenz verursachen. In der Praxis muss daher der Herstellungsprozess sehr genau auf eine Ausgangsfrequenz eingestellt werden. In der elektronischen Domäne ist jedoch die Frequenzkonversion Routine, daher kann eine bekannte Frequenzabweichung zumindest hier korrigiert werden und die Stabilität dennoch genutzt werden. Für viele Anwendungen ist zudem eine stabile, genau bekannte Frequenz ausreichend.

Dadurch, dass die Modenindizes ganze Zahlen sind, wird die oben beschriebene Auslegungsbedingung in der Praxis nicht genau erfüllt werden, da die Dimensionen, Brechungsindizes und thermische Abhängigkeiten gewissen Fabrikationsschwankungen unterliegen werden. Zwei hier bisher vernachlässigte Effekte können dazu benutzt werden, um dennoch einen Nulldurchgang der Temperaturabhängigkeit zu erzeugen: Erstens unterliegen die Moden im Allgemeinen verschiedenen Dispersionsrelationen, sodass die Brechungsindizes (bei konstanter Temperatur) durch die Wahl der Modenindizes $m_1$ und $m_2$ fein, wenngleich in Stufen, verändert werden können. Zweitens unterliegen die Moden auch thermischen Koeffizienten höherer Ordnung, sodass die Werte $\beta_1$ und $\beta_2$ durch Änderung der Arbeitspunkttemperatur fein eingestellt werden können.

Eine weitere Variante, um ein stabiles Modenpaar zu erzeugen, ist die Kopplung zweier Moden. Diese Kopplung kann in einem einzelnen Ring durch ein reflektierendes Element erzeugt werden, oder kann durch evaneszente Kopplung zweier Ringe erzeugt werden (vgl. Ref. 5).

In einem einzelnen Ring werden dadurch die Varianten einer räumlichen Mode, welche im und gegen den Uhrzeigersinn im Ring propagieren, gekoppelt. Da die räumlichen Moden nominell identisch sind, werden auch deren thermische Koeffizienten nahezu gleich sein, wodurch eine hohe Stabilität erwartet werden kann. Die Stärke der Kopplung, welche in diesem Fall genau die Referenzfrequenz $\Delta f$ darstellt, kann durch die Reflektivität bestimmt werden. Ein einfaches reflektierendes Element (wie in Ref. 5 verwendet) wird jedoch im Allgemeinen zu Streuverlusten führen, da es eine nichtadiabatische Änderung der Modenparameter und dadurch eine Streuung in freie Moden im Mantel verursacht.

Durch Verwendung zweier Ringe können diese Verluste größtenteils vermieden werden, da die Kopplung mittels Evaneszenz zwischen den Moden der Ringe entstehen kann, wodurch sich die Propagationsparameter nur langsam entlang der Ringe ändern. Diese Variante der Anwendung eignet sich gut für stabile Frequenzen $\Delta f$ im Bereich um 250 MHz. Dieser Wert ergibt sich daraus, dass die Linienbreiten guter Ringresonatoren mit Durchmessern um 1 cm im Bereich von 10 MHz liegen, während der Abstand zwischen zwei Moden bei dieser Dimensionierung 6,5 GHz beträgt (Ref. 4). Die stabile Frequenzdifferenz $\Delta f$ ist damit deutlich größer als die Linienbreite, wodurch die Moden gut aufgelöst werden können. Andererseits ist sie deutlich kleiner als der Modenabstand in einem Ring, wodurch der Überlapp mit der nächsten Mode verschwindend klein ist. Die Kopplungsstärke zwischen den Ringen hängt exponentiell von dem Mindestabstand der Ringe ab (welche nicht konzentrisch sein müssen), und kann dadurch gewählt werden. Durch die Kopplung entstehen dort, wo die Moden der zwei einzelnen Ringe die gleiche Frequenz $f_0$ haben, zwei Moden, welche durch die Kopplung 2g aufgespalten sind. Der Frequenzabstand $\Delta f_K(T)$ zwischen den zwei Moden für Ringe mit thermischen Koeffizienten $\beta_1$ und $\beta_2$ ist gegeben durch

$$\Delta f_g(T) = 2g\sqrt{1+\left(f_0\frac{\beta_1-\beta_2}{2g}T\right)^2} \cong 2g + \frac{1}{4g}\left((\beta_1-\beta_2)f_0 T\right)^2,$$

welcher also auf Resonanz zu erster Ordnung temperaturunempfindlich ist. Hier wurden mehrere kleine Korrekturen vernachlässigt, beispielsweise ein kleiner Schub der Temperatur $\left(\sim\left(\frac{2g}{f_0}\right)^2\frac{\sqrt{\beta_1\beta_2}}{(\beta_1-\beta_2)^2}\right)$, welcher für die hier verwendeten Parameter viel kleiner als 1 Kelvin ist, wie auch ein weiterer Schub durch die endliche Breite und Asymmetrie der Resonanzlinien, und ein Schub durch eine geringe Temperaturabhängigkeit der Kopplungsstärke. In der Praxis müssen diese Schübe durch Vermessung bestimmt werden. Des Weiteren werden im Allgemeinen die Resonanzfrequenzen der zwei Ringe nicht bei der erwünschten Arbeitspunkttemperatur identisch sein. Durch den Unterschied in den thermischen Koeffizienten $\beta_1$ und $\beta_2$ können die Ringe aber in Resonanz gebracht werden. Da der quadratische Term der Temperaturabhängigkeit aber auch von diesem Unterschied abhängt, gilt es, die Empfindlichkeit gegen die Verstimmbarkeit abzugleichen. Beispielsweise ist bei einem Unterschied der Temperaturkoeffizienten von 0,2% eine thermische Stimmung von ca. $\pm15K$ notwendig, um die Resonanzbedingung zu erreichen. Nichtsdestotrotz kann diese Variante dann zur Erzeugung einer stabilen Referenzfrequenz verwendet werden, wobei eine weitere Mode des Systems oder eines dritten Ringes als temperaturabhängiges Element zur erfindungsgemäßen Langzeitstabilisierung dienen kann. Es sei an dieser Stelle angemerkt, dass der gleiche Effekt auch mit gekoppelten Fabry-Perot-Resonatoren erzielt werden kann.

Eine Variante mit drei verschiedenen Resonatoren ist in Fig. 8 gezeigt. Hier wird das Licht aus drei verschiedenen, modulierten Laserlichtquellen - einer ersten Laserlichtquelle 18 zur Erzeugung von Licht der Frequenz f1, einer zweiten Laserlichtquelle 19 zur Erzeugung von Licht der Frequenz f2 und einer dritten Laserlichtquelle 20 zur Erzeugung von Licht der Frequenz f3 - in drei Wellenleiter - einen ersten Wellenleiter 21, einen zweiten Wellenleiter 22 und einen dritten Wellenleiter 23 - geführt. Die Moden dieser Wellenleiter überlappen geringfügig mit denen dreier Ringresonatoren - eines ersten Ringresonators 24, eines zweiten Ringresonators 25 und eines dritten Ringresonators 26 - und koppeln dadurch evaneszent Licht in deren ausgewählte Resonanzmoden. Das transmittierte Licht wird von jeweiligen Detektoren - einem ersten Detektor 27, einem zweiten Detektor 28 und einem dritten Detektor 29 gesammelt. Auch hier wird, mittels der durch die Modulation erzeugten Seitenbänder, die Frequenz jedes Lasers 18, 19, 20 auf die erwünschte Resonanz im jeweiligen Ring 24, 25, 26 gehalten, sodass die Frequenzen f1, f2, f3 stabilisiert werden. Dafür wird wieder das Pound-Drever-Hall-Verfahren (Ref. 6) benutzt. Die Modulation der Laser 18, 19, 20, die Demodulation der Detektorsignale und die Regelung des Laserstroms werden an den integrierten Elektronikmodulen 37 vorgenommen. Dort wird die aus der Demodulation ersichtliche Abweichung der Laserfrequenz von der Resonatormodenfrequenz durch eine Korrektur des Laserstroms für jede Laserlichtquelle 18, 19, 20 einzeln vorgenommen.

Des Weiteren wird das Licht aus den Laserlichtquellen 18 und 19 mittels integrierter Strahlteiler - eines ersten Strahlteilers 30 und eines zweiten Strahlteilers 31 - an einen weiteren, vierten Detektor 32 geführt, an dem die Schwebungsfrequenz $\Delta f$ zwischen den zwei Modenfrequenzen f1, f2 in den Ringen 24 und 25 gemessen wird. Dasselbe Verfahren kann für die Laserlichtquellen 19 und 20 über den zweiten Strahlteiler 31 und einen dritten Strahlteiler 33 verwendet werden, um auf einem fünften Detektor 34 die Schwebung f4 zwischen den Modenfrequenzen f2 und f3 der Ringe 25 und 26 zu messen.

Aufgrund der Beschriebenen Auslegung der Resonatoren 24, 25 ist die Schwebungsfrequenz $\Delta f$ auf dem vierten Detektor 32 hochstabil, während die Schwebungsfrequenz f4 auf Detektor 34 störungsempfindlich ist. Ein Teil des Lichtes, welches die stabile Schwebungsfrequenz $\Delta f$ trägt, kann nun als optisches Signal vom Chip an einem optischen Ausgang 36 weggeleitet werden und über optische Fasern oder als Freistrahl an andere Geräte verteilt werden.

Weiters können die ermittelten Schwebungsfrequenzen genau wie in der vorherigen Beschreibung zur Selbststabilisierung der Vorrichtung bzw. der Referenzfrequenz $\Delta f$ dienen: An einer Elektronik 38 können die Schwebungsfrequenzen $\Delta f$ und f4 aus den Detektoren 32 und 34 wieder verglichen werden, und Änderungen vom voreingestellten Sollwert für die Regelung einer Heizstromquelle verwendet werden. Dadurch kann die Temperatur des Chips, und somit die Taktgeberfrequenz, präzise stabilisiert werden.

Vorzugsweise muss dies deutlich langsamer geschehen als die Korrektur der Laserströme. In der Praxis ist diese Bedingung leicht erfüllt, da die thermische Regulierung bestenfalls auf Millisekunden-Skala geschehen kann, während die Laserströme in weniger als einer Mikrosekunde korrigiert werden können.

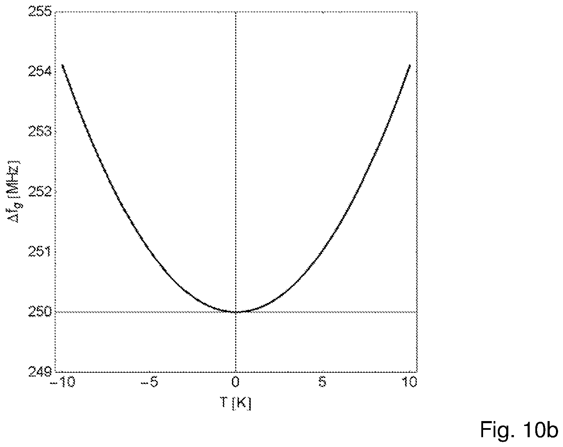

Eine Variante mit gekoppelten Resonatoren ist schließlich in Fig. 9 gezeigt. Alle Elemente behalten ihre Funktion wie in Fig. 8, bis auf die Ringe 25 und 26, welche durch das gekoppelte Ringresonatorpaar 35 ersetzt werden. In dieser Abbildung wurden die Lasermodulations-und regelschleifen, sowie die Temperaturregelung, der Übersichtlichkeit halber ausgelassen, führen hier jedoch ebenfalls die gleichen Funktionen wie in Fig. 8 aus. Die Moden aus den Quellen 18 und 19 koppeln hier über die Welleinleiter 21 und 22 an jeweils eine Mode des stabilen Modenpaars im Ringresonatorpaar 35. Zur Veranschaulichung hiervon dienen Fig. 10a und Fig. 10b.

In Fig. 10a wird die Kreuzung zwischen zwei Moden des gekoppelten Ringresonatorpaars 35 gezeigt. Die gestrichelten Linien stellen die Frequenzen der Moden der einzelnen Resonatoren des Ringresonatorpaars 35 dar, während die durchgehenden Linien die Frequenzen der Moden des gekoppelten Systems zeigen. Durch die verschiedenen thermischen Koeffizienten kreuzen sich die Frequenzen der einzelnen Ringe. Durch die Kopplung kommt es um die Resonanz zum nahezu parallelen Verlauf der Frequenzen des gekoppelten Systems.

In Fig. 10b wird der Verlauf des Frequenzunterschieds $\Delta f_g(T)$ gezeigt, für einen Unterschied von 0,2% zwischen den thermischen Koeffizienten und eine Kopplungsfrequenz von 2g=250 MHz. Es sei hier angemerkt, dass die Chip-integrierten Resonatoren natürlich auch für die Frequenzkamm-basierte (anhand von Fig. 5 und Fig. 6 beschriebene) Stabilisierung geeignet sind, und somit zur integrierten Stabilisierung chipbasierter Frequenzkämme benutzt werden können.

In den vorangehenden Beschreibungen wurde durchgehend von an sich instabilen Lichtquellen ausgegangen. Wenn eine Lichtquelle mit geringen Frequenzschwankungen um eine Frequenz f1 vorhanden ist, kann das Prinzip der Erfindung ebenso dafür benutzt werden, um diese Stabilität auf die Differenzfrequenz f2-f1 zu übertragen. Dabei werden die Schwankungen der Lichtquellenfrequenz durch die geringere (z.B. quadratische oder kubische) Abhängigkeit der Differenzfrequenz zusätzlich unterdrückt.

Abschließend sei ganz allgemein zur Materialwahl folgendes bemerkt: Als Materialien werden für Wellenleitersysteme bei Wellenlänge $\lambda \approx 1,5 \ \mu$m für gewöhnlich Siliziumoxid, Titanoxid, Silizium oder Siliziumnitrid verwendet. Als Spiegelsubstrat kann jedes Material verwendet werden, welches in dem angepeilten Wellenlängenbereich transparent ist und in die richtige Form gefräst und poliert (oder auf andere Weise in der richtigen Form erzeugt) werden kann. Für die genannten 1,5 $\mu$m Wellenlänge sind Quarzglas und Silizium sinnvoll. Als Halterung (vgl. Halterung 3 in Fig. 1) können Metalle, Kristalle (z.B. Silizium oder Quarzglas) oder Keramiken verwendet werden.

BEZUGSZEICHENLISTE

| | |
|---|---|
| 1 | Erster Spiegel |
| 2 | Zweiter Spiegel |
| 3 | Halterung |
| 3a | Fabry-Perot-Resonator |
| 4 | Laser |
| 4a | Elektrooptischer Modulator |
| 4b | Polarisierender Strahlteiler |
| 4c | Viertelwellenretardationsoptik |
| 4d | Demodulator |
| 5 | Strahlteiler |
| 6 | Akustooptischer Frequenzschieber |
| 6a | Zweiter elektrooptischer Modulator |
| 6b | Zweiter polarisierender Strahlteiler |
| 6c | Zweite Viertelwellenretardationsoptik |
| 6d | Zweiter Demodulator |
| 6e | strukturierte Phasenplatte |
| 7 | Oszillator |
| 8 | Temperaturregler |
| 9 | Frequenzmultiplikator |
| 10 | Weiterer akustooptischer Modulator |
| 10a | Weiterer elektrooptischer Modulator |
| 10d | Dritter Demodulator |
| 11 | Optischer Zirkulator |
| 12 | Heizstromquelle |
| 13 | Weitere Polarisationsoptik |
| 14 | Frequenzteiler |
| 15 | Frequenzkamm |
| 16 | Photodiode |
| 17 | Weiterer Frequenzmultiplikator |
| 17a | Frequenzkomparator |
| 18 | Erste Laserlichtquelle |
| 19 | Zweite Laserlichtquelle |
| 20 | Dritte Laserlichtquelle |
| 21 | Erster Wellenleiter |
| 22 | Zweiter Wellenleiter |
| 23 | Dritter Wellenleiter |
| 24 | Erster Ringresonator |
| 25 | Zweiter Ringresonator |
| 26 | Dritter Ringresonator |
| 27 | Erster Detektor |
| 28 | Zweiter Detektor |
| 29 | Dritter Detektor |
| 30 | Erster Strahlteiler |
| 31 | Zweiter Strahlteiler |
| 32 | Vierter Detektor |
| 33 | Dritter Strahlteiler |
| 34 | Fünfter Detektor |
| 35 | Gekoppeltes Ringresonatorpaar |
| 36 | Optischer Ausgang |
| 37 | Elektronikmodule |
| 38 | Elektronik |

**Patentansprüche**

1. Verfahren zur Erzeugung einer Referenzfrequenz $\Delta f$ unter Verwendung eines ersten optischen Resonators (3a; 24) und eines zweiten optischen Resonators (25),
   wobei der erste Resonator (3a; 24) eine erste Resonatormode mit einer ersten Frequenz f1 aufweist und der zweite Resonator (25) eine zweite Resonatormode mit einer zweiten Frequenz f2, wobei die Frequenzen der beiden Resonatormoden Funktionen eines Betriebsparameters BP, insbesondere einer Temperatur, sind und die Werte f1 und f2 bei einem vorgegeben Wert $BP_0$ des Betriebsparameters annehmen, sodass f1($BP_0$)=f1 und f2($BP_0$)=f2 gilt, wobei Licht der ersten Frequenz f1 mittels des ersten Resonators auf die erste Frequenz f1 stabilisiert wird und Licht der zweiten Frequenz f2 mittels des zweiten Resonators auf die zweite Frequenz f2
und wobei die Differenz zwischen den stabilisierten Frequenzen f1 und f2, Δf = |f1 - f2|, bestimmt wird, um die stabilisierte Referenzfrequenz Δf zu erhalten,
**dadurch gekennzeichnet, dass** die Resonatoren (3a; 24, 25) so ausgelegt werden, dass die erste Ableitung der Frequenzen f1(BP), f2(BP) nach BP oder zumindest ein Differenzenquotient rund um $BP_0$ bis auf eine Abweichung von maximal ±0,1% übereinstimmen.

2. Verfahren nach Anspruch 1 **dadurch gekennzeichnet, dass** der erste optische Resonator (3a; 24) eine Resonatorlänge $L_1$ und einen linearen Temperaturkoeffizienten $\beta_1$ aufweist und der zweite optische Resonator (25) eine Resonatorlänge $L_2$ und einen linearen Temperaturkoeffizienten $\beta_2$,
wobei die Resonatoren (3a; 24, 25) so ausgelegt werden,
dass $m_1{}^*\beta_1{}^*L_2{}^*n_2 = m_2{}^*\beta_2{}^*L_1{}^*n_1$ bis auf eine Abweichung von maximal ±0,1% gilt mit $m_1$, $m_2$ ganzen Zahlen, die der Anzahl der Wellenlängen der ersten bzw. zweiten Resonatormode im ersten bzw. zweiten Resonator entsprechen, und $n_1$, $n_2$ den Brechungsindizes für die erste Resonatormode im ersten Resonator (3a; 24) und die zweite Resonatormode im zweiten Resonator (25)
oder dass im ersten und zweiten Resonator (35) gekoppelte Moden vorliegen und ein aufgrund der Kopplung aufgespaltetes Modenspektrum die erste Resonatormode und die zweite Resonatormode enthält.

3. Verfahren nach einem der Ansprüche 1 bis 2, **dadurch gekennzeichnet, dass** der erste Resonator (3a) gleichzeitig auch den zweiten Resonator ausbildet und identisch mit diesem ist.

4. Verfahren nach Anspruch 3, **dadurch gekennzeichnet, dass** die Modenkopplung mittels eines zumindest teilweise reflektierenden Elements erzeugt wird.

5. Verfahren nach einem der Ansprüche 1 bis 2, **dadurch gekennzeichnet, dass** die Modenkopplung durch evaneszente Kopplung des ersten Resonators mit dem zweiten Resonator erzeugt wird.

6. Verfahren nach einem der Ansprüche 1 bis 3, **dadurch gekennzeichnet, dass** die beiden Resonatormoden durch jeweils einen longitudinalen Index und zwei transversale Indizes beschreibbar sind, wobei die erste Resonatormode und die zweite Resonatormode denselben longitudinalen Index und zumindest einen unterschiedlichen transversalen Index aufweisen.

7. Verfahren nach einem der Ansprüche 1 bis 6, **dadurch gekennzeichnet, dass** Licht einer dritten Frequenz f3 erzeugt und mittels eines Resonators (3a; 26) stabilisiert wird,
wobei f3 eine größere Abhängigkeit vom Betriebsparameter, insbesondere von der Temperatur, als Δf aufweist,
dass eine Vergleichsfrequenz f4 durch

$$f4 = |f3 - f1| \text{ oder } f4 = |f3 - f2|$$

gegeben ist
und dass das Verhältnis f4/Δf oder die Differenz f4-Δf bestimmt und zur Steuerung von Betriebsparameterregelmitteln, insbesondere Temperaturregelmitteln (12), welche zur Regelung des Betriebsparameters, insbesondere der Temperatur, des ersten Resonators (3a; 24) und/oder zweiten Resonators (3a; 25) vorgesehen sind, verwendet wird.

8. Verfahren nach Anspruch 7, **dadurch gekennzeichnet, dass** zur Stabilisierung des Lichts der dritten Frequenz f3 der erste Resonator (3a; 24) und/oder der zweite Resonator (3a; 25) oder ein dritter Resonator (26) verwendet werden.

9. Verfahren nach einem der Ansprüche 7 bis 8, **dadurch gekennzeichnet, dass** das Licht der dritten Frequenz f3 durch eine Kammmode eines Frequenzkamms (15) ausgebildet wird.

10. Verfahren nach einem der Ansprüche 1 bis 9, **dadurch gekennzeichnet, dass** als erster Resonator und/oder als zweiter Resonator ein Fabry-Perot-Resonator (3a) verwendet wird.

11. Verfahren nach einem der Ansprüche 1 bis 10, **dadurch gekennzeichnet, dass** als erster Resonator und/oder als zweiter Resonator ein optischer Ringresonator (24, 25) verwendet wird.

12. Verfahren nach einem der Ansprüche 1 bis 11, **dadurch gekennzeichnet, dass** als erster Resonator (3a; 24) und/oder als zweiter Resonator (3a; 25) ein als Wellenleiter auf einem optischen Chip ausgebildeter optischer Resonator verwendet wird.

13. Vorrichtung zur Erzeugung einer Referenzfrequenz $\Delta f$,
wobei ein erster optischer Resonator (3a; 24) vorgesehen ist, der eine erste Resonatormode mit einer ersten Frequenz f1 aufweist, und ein zweiter optischer Resonator (25), der eine zweite Resonatormode mit einer zweiten Frequenz f2 aufweist,
wobei die Frequenzen der beiden Resonatormoden Funktionen eines Betriebsparameters BP, insbesondere einer Temperatur, sind und die Werte f1 und f2 bei einem vorgegeben Wert $BP_0$ des Betriebsparameters annehmen, sodass f1($BP_0$)=f1 und f2($BP_0$)=f2 gilt,
die Vorrichtung weiters umfassend erste Lichterzeugungsmittel (4; 18) zur Erzeugung von Licht der ersten Frequenz f1 und zweite Lichterzeugungsmittel (4, 6; 19) zur Erzeugung von Licht der zweiten Frequenz f2, wobei die ersten Lichterzeugungsmittel (4; 18) und die zweiten Lichterzeugungsmittel (4, 6; 19) vorzugsweise insgesamt mindestens einen Laser umfassen,
die Vorrichtung weiters umfassend erste Stabilisierungsmittel, um die erste Frequenz f1 zu stabilisieren, und zweite Stabilisierungsmittel, um die zweite Frequenz f2 zu stabilisieren,
und wobei Bestimmungsmittel vorgesehen sind, um die Differenz zwischen den stabilisierten Frequenzen f1 und f2, $\Delta f$ = |f1 - f2|, zu bestimmen und die stabilisierte Referenzfrequenz $\Delta f$ zu erhalten,
**dadurch gekennzeichnet, dass** die Resonatoren (3a; 24, 25) so ausgelegt sind, dass die erste Ableitung der Frequenzen f1(BP), f2(BP) nach BP oder zumindest ein Differenzenquotient rund um $BP_0$ bis auf eine Abweichung von maximal $\pm 0{,}1\%$ übereinstimmen.

14. Vorrichtung nach Anspruch 13, **dadurch gekennzeichnet, dass** der erste optische Resonator (3a; 24) eine Resonatorlänge $L_1$ und einen linearen Temperaturkoeffizienten $\beta_1$ aufweist und der zweite optische Resonator (25) eine Resonatorlänge $L_2$ und einen linearen Temperaturkoeffizienten $\beta_2$,
wobei die Resonatoren (3a; 24, 25) so ausgelegt sind,
dass $m_1 * \beta_1 * L_2 * n_2 = m_2 * \beta_2 * L_1 * n_1$ bis auf eine Abweichung von maximal $\pm 0{,}1\%$ gilt mit $m_1$, $m_2$ ganzen Zahlen, die der Anzahl der Wellenlängen der ersten bzw. zweiten Resonatormode im ersten bzw. zweiten Resonator entsprechen, und $n_1$, $n_2$ den Brechungsindizes für die erste Resonatormode im ersten Resonator (3a; 24) und die zweite Resonatormode im zweiten Resonator (25)
oder dass im ersten und zweiten Resonator (35) gekoppelte Moden vorliegen und ein aufgrund der Kopplung aufgespaltetes Modenspektrum die erste Resonatormode und die zweite Resonatormode enthält.

15. Vorrichtung nach einem der Ansprüche 13 bis 14,
**dadurch gekennzeichnet, dass** die ersten Stabilisierungsmittel erste Modulationsmittel (4a; 37) umfassen, um dem Licht erster Frequenz f1 Seitenbänder aufzumodulieren, und erste Demodulationsmittel (4d; 27, 37) mit einem ersten Detektor, um mittels des zum ersten Detektor zurück reflektierten oder transmittierten modulierten Lichts erster Frequenz f1
ein erstes Fehlersignal zu erzeugen, sowie erste Regelmittel (37), um anhand des ersten Fehlersignals die ersten Lichterzeugungsmittel (4; 18) so zu regeln, dass die erste Frequenz f1 stabilisiert wird,
und dass die zweiten Stabilisierungsmittel zweite Modulationsmittel (6a; 37) umfassen, um dem Licht zweiter Frequenz f2 Seitenbänder aufzumodulieren, und zweite Demodulationsmittel (6d; 28, 37) mit einem zweiten Detektor, um mittels des zum zweiten Detektor zurück reflektierten oder transmittierten modulierten Lichts zweiter Frequenz f2 ein zweites Fehlersignal zu erzeugen, sowie zweite Regelmittel (37), um anhand des zweiten Fehlersignals die zweiten Lichterzeugungsmittel (4, 6; 19) so zu regeln, dass die zweite Frequenz f2 stabilisiert wird.

**Claims**

1. Method for producing a reference frequency $\Delta f$ using a first optical resonator (3a; 24) and a second optical resonator (25),
wherein the first resonator (3a; 24) has a first resonator mode with a first frequency f1 and the second resonator (25) has a second resonator mode with a second frequency f2, wherein the frequencies of the two resonator modes are functions of an operating parameter BP, in particular of a temperature, and take on the values f1 and f2 at a set value $BP_0$ of the operating parameter, so that f1($BP_0$) = f1 and f2($BP_0$) = f2,

wherein light of the first frequency f1 is stabilized at the first frequency f1 by means of the first resonator, and light of the second frequency f2 is stabilized at the second frequency f2 by means of the second resonator,

and wherein the difference between the stabilized frequencies f1 and f2, $\Delta f = |f1 - f2|$, is determined, in order to obtain the stabilized reference frequency $\Delta f$

**characterized in that** the resonators (3a; 24, 25) are designed so that the first derivative of the frequencies f1(BP), f2(BP) with respect to BP, or at least a difference quotient around $BP_0$, corresponds up to a deviation of a maximum of $\pm 0.1\%$.

2. Method according to claim 1, **characterized in that** the first optical resonator (3a; 24) has a resonator length $L_1$ and a linear temperature coefficient $\beta_1$ and the second optical resonator (25) has a resonator length $L_2$ and a linear temperature coefficient $\beta_2$, wherein the resonators (3a; 24, 25) are designed so that $mi^*\beta_1^*L_2^*n_2 = m_2^*\beta_2^*L_1^*n_1$ up to a deviation of a maximum of $\pm 0.1\%$, with $m_1$, $m_2$ being whole numbers, which correspond to the wavelength numbers of the first or second resonator mode in the first or second resonator, and $n_1$, $n_2$ being the refractive indices for the first resonator mode in the first resonator (3a; 24) and the second resonator mode in the second resonator (25),

or that coupled modes are present in the first and second resonator (35), and a mode spectrum that is split because of the coupling contains the first resonator mode and the second resonator mode.

3. Method according to one of claims 1 to 2, **characterized in that** the first resonator (3a) simultaneously also forms the second resonator and is identical to it.

4. Method according to claim 3, **characterized in that** the mode coupling is produced by means of an at least partially reflecting element.

5. Method according to one of claims 1 to 2, **characterized in that** the mode coupling is produced by evanescent coupling of the first resonator to the second resonator.

6. Method according to one of claims 1 to 3, **characterized in that** the two resonator modes can each be described by a longitudinal index and two transversal indices, wherein the first resonator mode and the second resonator mode have the same longitudinal index and at least one different transversal index.

7. Method according to one of claims 1 to 6, **characterized in that** light of a third frequency f3 is produced and is stabilized by means of a resonator (3a; 26), wherein f3 has a greater dependence on the operating parameter, in particular on the temperature, than $\Delta f$,

that a comparison frequency f4 is given by

$$f4 = |f3 - f1| \text{ or } f4 = |f3 - f2|$$

and that the ratio f4/$\Delta f$ or the difference f4 - $\Delta f$ is determined and is used to control operating parameter regulating means, in particular temperature regulating means (12), which are provided to regulate the operating parameter, in particular the temperature, of the first resonator (3a; 24) and/or second resonator (3a; 25).

8. Method according to claim 7, **characterized in that** the first resonator (3a; 24) and/or the second resonator (3a; 25) or a third resonator (26) is used to stabilize the light of the third frequency f3.

9. Method according to one of claims 7 to 8, **characterized in that** the light of the third frequency f3 is formed by a comb mode of a frequency comb (15).

10. Method according to one of claims 1 to 9, **characterized in that** a Fabry-Perot resonator (3a) is used as the first resonator and/or as the second resonator.

11. Method according to one of claims 1 to 10, **characterized in that** an optical ring resonator (24, 25) is used as the first resonator and/or as the second resonator.

12. Method according to one of claims 1 to 11, **characterized in that** an optical resonator made as a waveguide on an optical chip is used as the first resonator (3a; 24) and/or as the second resonator (3a; 25).

13. Device for production of a reference frequency $\Delta f$, wherein a first optical resonator (3a; 24), which has a first resonator mode with a first frequency f1, and a second optical resonator (25), which has a second resonator mode with a second frequency f2, are provided,
wherein the frequencies of the two resonator modes are functions of an operating parameter BP, in particular of a temperature, and take on the values f1 and f2 at a set value $BP_0$ of the operating parameter, so that $f1(BP_0) = f1$ and $f2(BP_0) = f2$,
the device further comprising first light producing means (4; 18) to produce light of the first frequency f1 and second light producing means (4, 6; 19) to produce light of the second frequency f2, wherein the first light producing means (4; 18) and the second light producing means (4, 6; 19) preferably together comprise at least one laser,
the device further comprising first stabilization means to stabilize the first frequency f1, and second stabilization means to stabilize the second frequency f2,
and wherein determination means are provided, in order to determine the difference between the stabilized frequencies f1 and f2, $\Delta f = |f1 - f2|$, and to obtain the stabilized reference frequency $\Delta f$,
**characterized in that** the resonators (3a; 24, 25) are designed so that the first derivative of the frequencies f1(BP), f2(BP) with respect to BP, or at least a difference quotient around $BP_0$, corresponds up to a deviation of a maximum of $\pm 0.1\%$.

14. Device according to claim 13, **characterized in that** the first optical resonator (3a; 24) has a resonator length $L_1$ and a linear temperature coefficient $\beta_1$ and the second optical resonator (25) has a resonator length $L_2$ and a linear temperature coefficient $\beta_2$, wherein the resonators (3a; 24, 25) are designed so
that $m_1 * \beta_1 * L_2 * n_2 = m_2 * \beta_2 * L_1 * n_1$ up to a deviation of a maximum of $\pm 0.1\%$, with $m_1$, $m_2$ being whole numbers, which correspond to the wavelength number of the first or second resonator mode in the first or second resonator, and $n_1$, $n_2$ being the refractive indices for the first resonator mode in the first resonator (3a; 24) and the second resonator mode in the second resonator (25),
or that coupled modes are present in the first and second resonator (35), and a mode spectrum that is split because of the coupling contains the first resonator mode and the second resonator mode.

15. Device according to on of claims 13 to 14, **characterized in that** the first stabilization means comprises first modulation means (4a; 37) to modulate side bands on the light of the first frequency f1, and first demodulation means (4d; 27, 37) with a first detector to produce a first error signal by means of the modulated light of the first frequency f1 that is reflected back or transmitted to the first detector, and first regulating means (37) to regulate, by means of the first error signal, the first light producing means (4; 18) so that the first frequency f1 is stabilized,
and that the second stabilization means comprise second modulation means (6a; 37) to modulate side bands on the light of the second frequency f2, and second demodulation means (6d; 28, 37) with a second detector to produce a second error signal by means of the modulated light of the second frequency f2 that is reflected back or transmitted to the second detector, and second regulating means (37) to regulate, by means of the second error signal, the second light producing means (4, 6; 19) so that the second frequency f2 is stabilized.

**Revendications**

1. Procédé pour la génération d'une fréquence de référence $\Delta f$ en utilisant un premier résonateur optique (3a ; 24) et un deuxième résonateur optique (25),
dans lequel le premier résonateur (3a ; 24) présente un premier mode de résonateur avec une première fréquence f1 et le deuxième résonateur (25) présente un deuxième mode de résonateur avec une deuxième fréquence f2, les fréquences des deux modes de résonateur étant des fonctions d'un paramètre de fonctionnement BP, en particulier d'une température, et prenant les valeurs f1 et f2 à une valeur prédéterminée $BP_0$ du paramètre de fonctionnement, telle que $f1(BP_0) = f1$ et $f2(BP_0) = f2$,
dans lequel de la lumière de la première fréquence f1 est stabilisée au moyen du premier résonateur à la première fréquence f1 et la lumière de la deuxième fréquence f2 au moyen du deuxième résonateur à la deuxième fréquence f2 et dans lequel la différence entre les fréquences stabilisées f1 et f2, $\Delta f = |f1 - f2|$, est déterminée afin d'obtenir la fréquence de référence stabilisée $\Delta f$,
**caractérisé en ce que** les résonateurs (3a ; 24, 25) sont conçus de telle manière que la première dérivée des fréquences f1(BP), f2(BP) en fonction de BP ou au moins d'un quotient de différences autour de $BP_0$ concordent à un écart d'au maximum $\pm 0,1\%$ près.

**2.** Procédé selon la revendication 1, **caractérisé en ce que** le premier résonateur optique (3a ; 24) présente une longueur de résonateur $L_1$ et un coefficient de température linéaire $\beta_1$ et le deuxième résonateur optique (25) présente une longueur de résonateur $L_2$ et un coefficient de température linéaire $\beta_2$,
les résonateurs (3a ; 24, 25) étant conçus de telle sorte
**que** l'on ait $m_1 \times \beta_1 \times L_2 \times n_2 = m_2 \times \beta_2 \times L_1 \times n_1$ à un écart d'au maximum $\pm 0,1$ % près, où $m_1$, $m_2$ sont des nombres entiers qui correspondent au nombre de longueurs d'ondes du premier ou deuxième mode de résonateur dans le premier ou deuxième résonateur et $n_1$, $n_2$ aux indices de réfraction pour le premier mode de résonateur dans le premier résonateur (3a ; 24) et le deuxième mode de résonateur dans le deuxième résonateur (25)
ou que des modes couplés sont présents dans les premier et deuxième résonateurs (35) et un spectre de modes fractionné du fait du couplage contient le premier mode de résonateur et le deuxième mode de résonateur.

**3.** Procédé selon l'une des revendications 1 à 2, **caractérisé en ce que** le premier résonateur (3a) forme en même temps aussi le deuxième résonateur et est identique à celui-ci.

**4.** Procédé selon la revendication 3, **caractérisé en ce que** le couplage de mode est produit au moyen d'un élément au moins partiellement réfléchissant.

**5.** Procédé selon l'une des revendications 1 à 2, **caractérisé en ce que** le couplage de mode est produit par un couplage évanescent du premier résonateur avec le deuxième résonateur.

**6.** Procédé selon l'une des revendications 1 à 3, **caractérisé en ce que** les deux modes de résonateur peuvent être décrits chacun par un index longitudinal et deux index transversaux, le premier mode de résonateur et le deuxième mode de résonateur présentant le même index longitudinal et au moins un index transversal différent.

**7.** Procédé selon l'une des revendications 1 à 6, **caractérisé en ce que** de la lumière d'une troisième fréquence f3 est produite et stabilisée au moyen d'un résonateur (3a ; 26), f3 présentant une plus forte dépendance du paramètre de fonctionnement, en particulier de la température, que $\Delta f$,
**en ce qu'**une fréquence de comparaison f4 est donnée par

$$f4 = |f3 - f1| \text{ ou } f4 = |f3 - f2|$$

et **en ce que** le rapport $f4/\Delta f$ ou la différence $f4 - \Delta f$ est déterminé et utilisé pour commander des moyens de régulation du paramètre de fonctionnement, en particulier des moyens de régulation de la température (12), prévus pour réguler le paramètre de fonctionnement, en particulier la température, du premier résonateur (3a ; 24) et/ou du deuxième résonateur (3a ; 25).

**8.** Procédé selon la revendication 7, **caractérisé en ce que** le premier résonateur (3a ; 24) et/ou le deuxième résonateur (3a ; 25) ou un troisième résonateur (26) sont utilisés pour stabiliser la lumière de la troisième fréquence f3.

**9.** Procédé selon l'une des revendications 7 à 8, **caractérisé en ce que** la lumière de la troisième fréquence f3 est formée par un mode de peigne d'un peigne de fréquences (15).

**10.** Procédé selon l'une des revendications 1 à 9, **caractérisé en ce que** le premier résonateur et/ou le deuxième résonateur sont des résonateurs de Fabry-Pérot (3a).

**11.** Procédé selon l'une des revendications 1 à 10, **caractérisé en ce que** le premier résonateur et/ou le deuxième résonateur sont des résonateurs optiques en anneau (24, 25).

**12.** Procédé selon l'une des revendications 1 à 11, **caractérisé en ce que** le premier résonateur (3a ; 24) et/ou le deuxième résonateur (3a ; 25) sont des résonateurs optiques formés comme guides d'ondes sur une puce optique.

**13.** Dispositif pour la génération d'une fréquence de référence $\Delta f$,
dans lequel est prévu un premier résonateur optique (3a ; 24) qui présente un premier mode de résonateur avec une première fréquence f1 et un deuxième résonateur optique (25) qui présente un deuxième mode de résonateur avec une deuxième fréquence f2,
dans lequel les fréquences des deux modes de résonateur sont des fonctions d'un paramètre de fonctionnement BP, en particulier d'une température, et prennent les valeurs f1 et f2 à une valeur prédéterminée $BP_0$ du paramètre de fonctionnement, telle que $f1(BP_0)$ = f1 et $f2(BP_0)$ = f2,

le dispositif comprenant en outre des premiers moyens générateurs de lumière (4 ; 18) pour produire de la lumière de la première fréquence f1 et des deuxièmes moyens générateurs de lumière (4, 6 ; 19) pour produire la lumière de la deuxième fréquence f2, de préférence les premiers moyens générateurs de lumière (4 ; 18) et les deuxièmes moyens générateurs de lumière (4, 6 ; 19) comprenant en tout au moins un laser,

le dispositif comprenant en outre des premiers moyens de stabilisation pour stabiliser la première fréquence f1 et des deuxièmes moyens de stabilisation pour stabiliser la deuxième fréquence f2,

et dans lequel des moyens de détermination sont prévus pour déterminer la différence entre les fréquences stabilisées f1 et f2, $\Delta f = |f1 - f2|$, et obtenir la fréquence de référence stabilisée $\Delta f$,

**caractérisé en ce que** les résonateurs (3a ; 24, 25) sont conçus de telle manière que la première dérivée des fréquences f1(BP), f2(BP) en fonction de BP ou au moins d'un quotient de différences autour de $BP_0$ concordent à un écart d'au maximum $\pm 0,1$ % près.

14. Dispositif selon la revendication 13, **caractérisé en ce que** le premier résonateur optique (3a ; 24) présente une longueur de résonateur $L_1$ et un coefficient de température linéaire $\beta_1$ et le deuxième résonateur optique (25) présente une longueur de résonateur $L_2$ et un coefficient de température linéaire $\beta_2$,

les résonateurs (3a ; 24, 25) étant conçus de telle sorte

**que** l'on ait $m_1 \times \beta_1 \times L_2 \times n_2 = m_2 \times \beta_2 \times L_1 \times n_1$ à un écart d'au maximum $\pm 0,1$ % près, où $m_1$, $m_2$ sont des nombres entiers qui correspondent au nombre de longueurs d'ondes du premier ou deuxième mode de résonateur dans le premier ou deuxième résonateur et $n_1$, $n_2$ aux indices de réfraction pour le premier mode de résonateur dans le premier résonateur (3a ; 24) et le deuxième mode de résonateur dans le deuxième résonateur (25)

ou que des modes couplés sont présents dans les premier et deuxième résonateurs (35) et un spectre de modes fractionné du fait du couplage contient le premier mode de résonateur et le deuxième mode de résonateur.

15. Dispositif selon l'une des revendications 13 à 14, **caractérisé en ce que** les premiers moyens de stabilisation comprennent des premiers moyens de modulation (4a ; 37) pour moduler des bandes latérales dans la lumière de la première fréquence f1 et des premiers moyens de démodulation (4d ; 27, 37) avec un premier détecteur pour générer un premier signal de défaut au moyen de la lumière modulée de la première fréquence f1 reflété retour au premier détecteur ou transmise, ainsi que des premiers moyens de régulation (37) pour réguler les premiers moyens générateurs de lumière (4 ; 18) au moyen du premier signal de défaut de telle façon que la première fréquence f1 soit stabilisée,

et **en ce que** les deuxièmes moyens de stabilisation comprennent des deuxièmes moyens de modulation (6a ; 37) pour moduler des bandes latérales dans la lumière de la deuxième fréquence f2 et des deuxièmes moyens de démodulation (6d ; 28, 37) avec un deuxième détecteur pour générer un deuxième signal de défaut au moyen de la lumière modulée de la deuxième fréquence f2 reflété retour au deuxième détecteur ou transmise, ainsi que des deuxièmes moyens de régulation (37) pour réguler les deuxièmes moyens générateurs de lumière (4, 6 ; 19) au moyen du deuxième signal de défaut de telle façon que la deuxième fréquence f2 soit stabilisée.

Fig. 1

Fig. 2a

Fig. 2b

Fig. 3

Fig. 4

Fig. 5

Fig. 6

Fig. 8

a)

b)

c)

d)

Fig. 7

Fig. 9

Fig. 10a

Fig. 10b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2012320449 A1

- US 3826931 A


**In der Beschreibung aufgeführte Nicht-Patentliteratur**

- Quartz Crystal Resonators and Oscillators for Frequency Control and Timing Applications - A Tutorial. *J. R. Vig; Rev. 8.5.6.2, http://www.ieee-uffc.org/frequency-control*
- **P. MADDALONI ; M. BELLINI ; P. DE NATALE.** Laser-Based Measurements for Time and Frequency Domain Applications: A Handbook. Taylor & Francis, 2013
- **DREVER, R. W. P. ; HALL, J. L. ; KOWALSKI, F. V. ; HOUGH, J. ; FORD, G. M. ; MUNLEY, A. J. ; WARD, H.** Laser phase and frequency stabilization using an optical resonator. *Applied Physics B,* 1983, vol. 31 (2), 97-105

- **HAGEMANN, C. et al.** Ultrastable laser with average fractional frequency drift rate below 5x 10- 19/s. *Optics Letters,* 2014, vol. 39 (17), 5102-5105
- **D. T. SPENCER ; J. F. BAUTERS ; M. J. R. HECK ; J. E. BOWERS.** Integrated waveguide coupled Si3N4 resonators in the ultrahigh-Q regime. *Optica,* 20. September 2014, vol. 1 (3), 153
- **ZHANG, Z. ; DAINESE, M. ; WOSINSKI, L. ; QIU, M.** Resonance-splitting and enhanced notch depth in SOI ring resonators with mutual mode coupling. *Optics Express,* 2008, vol. 16 (7), 4621-4630